(19) Europäisches Patentamt

European Patent Office

Office européen des brevets

(11) **EP 1 134 618 A2**

(12) **EUROPEAN PATENT APPLICATION**

| | |
|---|---|
| (43) Date of publication:<br>**19.09.2001 Bulletin 2001/38** | (51) Int Cl.⁷: **G03F 9/00** |

(21) Application number: **01106221.3**

(22) Date of filing: **14.03.2001**

| | |
|---|---|
| (84) Designated Contracting States:<br>**AT BE CH CY DE DK ES FI FR GB GR IE IT LI LU**<br>**MC NL PT SE TR**<br>Designated Extension States:<br>**AL LT LV MK RO SI** | (71) Applicant: **Nikon Corporation**<br>**Tokyo 100-8331 (JP)** |
| (30) Priority: **14.03.2000 JP 2000071356**<br>**08.03.2001 JP 2001065078** | (72) Inventor: **Mizutani, Hideo, Nikon Corporation**<br>**Chiyoda-ku, Tokyo 100-8331 (JP)** |
| | (74) Representative: **Harrison, Michael Charles et al**<br>**Albihns GmbH,**<br>**Grasserstrasse 10**<br>**80339 München (DE)** |

(54) **Alignment for lithography**

(57)    An alignment method which performs alignment of a substrate on which a first mark is formed with respect to an exposure position, comprises measuring and storing a positional relationship between the first mark and a second mark formed in an area different from the first mark, and measuring a position of the second mark after the substrate is moved to a vicinity of the exposure position in a state in which relative positions of the first mark and the second mark are maintained to be substantially constant. The alignment of the substrate is performed based on the measurement result and the stored positional relationship.

FIG.1

**Description**

BACKGROUND OF THE INVENTION

1. Field of the Invention

The present invention relates to an alignment method, an exposure method, an exposure apparatus, and a device manufacturing method, and more particularly, to an alignment method, an exposure method and an exposure apparatus which are employed in transferring a mask pattern onto a substrate in a lithography step for manufacturing devices of various types, such as semiconductor devices, liquid crystal display (LCD) devices, plasma display devices, and thin film magnetic heads, and to a device manufacturing method using the exposure apparatus.

2. Description of the Related Art

For example, an ordinary semiconductor device is manufactured in such a manner that circuit patterns of multiple layers are overlaid on a wafer to have a predetermined positional relationship. For this reason, in an exposure apparatus of a full field exposure type (stepper type) or an exposure apparatus of scanning exposure type (step-and-scan type), which are used in the manufacture of the semiconductor devices or the like, are provided with an alignment sensor that has a high-precision function for detecting the positions of alignment marks (wafer marks) formed on a wafer on which photoresist is coated as an exposure-object substrate. According to the detection results, high-precision alignment has been performed between circuit patterns preformed in individual shot areas on the wafer and a reticle pattern that will be exposed as a mask.

Generally, conventional alignment methods are classified into the following two methods. In a first method, an off-the-axis alignment sensor is provided independent of a projection optical system. The off-the-axis alignment sensor is controlled to detect the positions of wafer marks provided in predetermined shot areas of a wafer. Based on the detection results, individual shot areas on the wafer are moved one after another to an exposure area of the projection optical system. In this case, the projection optical system is not used for the alignment. Therefore, as detecting light for the alignment sensor, for example, light from a halogen lamp or the like having a wide-band wavelength that is low in photosensitivity to the photoresist can be used to reduce thin film interference effects that can be caused by the photoresist overlaid on the wafer.

A second method uses an alignment sensor of either a through-the-reticle (TTR) type or a through-the-lens (TTL) type. Alignment light having the same wavelength band as that of exposure light is used; and through a projection optical system (reticle and projection optical system in the TTR method), the positions of wafer marks are detected. Based on the detection results, individual shot areas of the wafer are moved to the exposure area of the projection optical system by using, for example, a die-by-die method. Among these types, in the off-the-axis alignment sensor and the TTL-type alignment sensor, predetermined reference marks formed on a reference mark member prepared on a wafer stage is used to measure a base line which is a space between the detection center of the alignment sensor and the center (exposure center) of an image of a reticle pattern; and according to the base line, results of detection by the alignment sensor are corrected. In the TTL-type alignment sensor, the amount of the base line can be controlled to be significantly short; whereas, in the off-the-axis alignment sensor, the base line is as long as, for example, the width of a lens housing of the projection optical system.

In the above-described conventional alignment methods, the second method (exposure-light-using TTR alignment or TTL alignment) is superior in that error factors, such as variations in the base line, are less to allow high precision to be obtained. However, since the second method uses substantially monochromatic exposure light, due to effects, such as a thin-film interference of the photoresist overlaid on the wafer, depending on the condition of the step portions of the wafer marks and the like, difficulty can arise in the detection of the wafer marks. In addition, even in a case where reflection-preventing coating for the exposure light is applied on the surface of the photoresist or the substrate, reflecting light is reduced, making it difficult to detect wafer marks.

In this connection, development is in progress for a method in which alignment light of a wide band, a single wavelength or multiple wavelengths which are different from that of exposure light is used to detect wafer marks through a projection optical system. However, when the exposure light wavelength becomes in a range from an extreme ultraviolet range to a vacuum ultraviolet range as in the case of a KrF excimer laser (wavelength: 248 nm), and furthermore, as in the case of ArF excimer laser (wavelength: 193 nm), since the chromatic aberration with respect to alignment light having non-exposure wavelengths in the projection optical system is increased, the position-detection precision can decreases.

The first method (off-the-axis alignment) is superior in that an alignment optical system having a high flexibility can be configured without being restricted by the projection optical system, and the photoresist thin-film interference and effects caused by the reflection-preventing coating can be reduced. In the first method, however, since the base line is relatively long, the measurement precision can be reduced by variations in the base line according to slight variations in a stage system due to an exposure-light irradiation heat. To prevent this, for example, the measurement (base-line checking) frequency of the amount of the base line can be increased;

however, the throughput of the exposure step is decreased accordingly.

## SUMMARY OF THE INVENTION

In view of the above-described problems, a first object of the present invention is to provide an alignment method and an exposure method that enables high-precision alignment to be performed for an exposure-target substrate on which a photosensitive material is coated.

A second object of the present invention is to provide an alignment method and an exposure method that enable high-precision alignment to be performed for an exposure-target substrate when exposure is performed through a projection optical system.

Furthermore, another object of the present invention is to provide an exposure apparatus capable of implementing the aforementioned exposure method; and still another object of the invention is to provide a device manufacturing method that enables various devices to be manufactured using the aforementioned exposure method.

According to a first aspect of the present invention, there is provided an alignment method which performs alignment of a substrate on which a first mark is formed with respect to an exposure position, comprising:

measuring and storing a positional relationship between the first mark and a second mark formed in an area different from the first mark, and
measuring a position of the second mark after the substrate is moved to a vicinity of the exposure position in a state in which relative positions of the first mark and the second mark are maintained to be substantially constant, wherein
the alignment of the substrate is performed based on the measurement result and the stored positional relationship.

In one example of the alignment method according to the first aspect of the present invention, the second mark is formed on a member different from the substrate; specifically, the second mark is formed on a holding member which holds the substrate. In this case, the substrate is preferably transferred in a state where the substrate is held by the holding member between the measuring and storing of the positional relationship and the measuring of the position of the second mark. In another example of the alignment method according to the first aspect, the first mark is formed on the substrate in an area on which a photosensitive material is coated, and the second mark is formed on an area of the substrate from which the photosensitive material is removed.

According to the alignment method according to the first aspect of the present invention, in the first step of the measuring and storing of the positional relationship, the positions of the first mark on the substrate and the second mark can be detected by an off-the-axis type mark-detecting system that uses, for example, wide-band illuminating light (detecting light) having a wavelength band different from that of an exposure beam. As a result, even when the first mark is covered by the photosensitive material, high detection precision can be obtained. On the other hand, the second mark can be formed in an area not covered by the photosensitive material to thereby obtain high detection precision irrespective of the illumination light. Therefore, the relative position (relative coordinates of each shot area) of the first mark to the position of the second mark can be detected at high precision.

Suppose the second mark is not covered by the photosensitive material, and a projection system is used for exposure. In this case, high-precision detection can be performed for the second mark by, for example, a mark-detecting system of a TTR (through the reticle) type or type that uses light having the same wavelength band as that of the exposure beam or a TTL (through the lens) type. Based on the result of the detection and the relative position of the first mark, the first mark can be aligned with respect to an exposure position at high precision. In other words, high alignment precision substantially equivalent to that of TTR-type or TTL-type alignment performed using wide-band non-exposure beams, can be obtained.

According to a second aspect of the present invention, there is provided an exposure method which performs exposure of a substrate with an exposure beams through a mask, comprising:

exposing the substrate after the substrate is aligned with the mask by using the alignment method as recited in claim 1. According to the exposure method, the exposure can be performed at high overlapping precision.

According to a third aspect of the present invention, there is provided an exposure method which performs exposure of a second substance through a first substance with an exposure beam, comprising:

moving a movable body on which the second substance is mounted on a first coordinate system, and detecting a mark on the first substance and reference marks different from the mark with a first mark-detecting system, thereby obtaining first position information;
moving at least a part of the movable body including the second substance and the reference marks onto a second coordinate system, and detecting the reference marks with a second mask-detecting system, thereby obtaining second position information, the reference marks being respectively provided at a plurality of positions, and at least two of the reference marks being detected by at least one of the first mark-detecting system and the second mask-detecting system; and

controlling a movement of the second substance on the second coordinate system according to the first position information and the second position information, and exposing the second substance through the first substance with the exposure beams.

According to a fourth aspect of the present invention, there is provided an exposure apparatus which performs exposure of a substrate with an exposure beam through a mask, comprising:

a substrate stage which performs positioning of the substrate;
a first mark-detecting system which detects positions of a first mark on the substrate and a second mark formed in an area different from the first mark; and

a second mask-detecting system which detects the position of the second mark with a transfer position of a pattern of the mask being used as a reference. The above-described exposure apparatus allows the alignment method according to the first aspect of the present invention and the exposure method according to the second aspect of the present invention to be implemented.

In this case, it is preferable that the first mark is formed on the substrate in an area on which a photosensitive material is coated, the second mark is formed on the substrate, or on a holding member which is to hold the substrate and in an area on which the photosensitive material is not coated, and the first mark-detecting system detects a detection-target mark by using a detecting beam having a wavelength band that is different from that of the exposure beam and having a wavelength width that is wider than that of the exposure beam. In addition, it is preferable that the pattern of the mask is transferred onto the substrate through a projection system, and the second mask-detecting system detects the position of the second mark through at least a part of the projection system. In this case, it is preferable that the second mask-detecting system uses detecting light having the same wavelength band as that of the exposure beam. Thereby, effects in chromatic aberration of the projection system are suppressed to allow high measurement precision to be obtained.

In addition, the substrate stage may comprise a first stage and a second stage which positions a first substrate and a second substrate as the substrate, respectively, and two units of the first mark-detecting systems may be provided corresponding to the first stage and the second stage. In the double-stage configuration, while alignment is performed using one of the stages, exposure can be performed using the other one of the stages; therefore, significantly high throughputs can be obtained.

Moreover, the double-stage configuration may be built to have an exchange mechanism which exchanges a portion of the first stage which holds the first substrate with at least a portion of the second stage which holds at least the second substrate.

Furthermore, in the present invention, the alignment position and the exposure position may be arranged at different positions. In this case, a carrying system may be provided to carry the substrate from a detection area of the second mask-detecting system onto the substrate stage.

According to a fifth aspect of the present invention, there is provided a device manufacturing method comprising: transferring a mask pattern onto a workpiece by using the exposure apparatus according to the fourth aspect of the present invention. According to the application of the device-manufacturing method of the fifth aspect of the present invention, mass-production of high-performance devices can be achieved.

According to a sixth aspect of the present invention, there is provided an exposure apparatus which performs exposure of a second substrate through a first substance with an exposure beam, comprising:

a movable body on which the second substance is mounted, and on which a plurality of reference marks which are different from a mark on the second substance are provided;
a first measurement system which includes a first mark-detecting system which detects the mark on the second substance and the reference marks, which defines a first coordinate system on which the movable body is disposed and on which a detection center of the first mark-detecting system is set, and which measures first position information regarding the mark on the second substance and the reference marks;
a second measurement system which includes a second mark-detecting system which detects the reference marks, which defines a second coordinate system on which at least a part of the movable body is disposed and on which a detection center of the second mark-detecting system is set, and which measures second position information regarding the reference marks, at least two of the plurality of reference marks being detected by at least one of the first measurement system and the second measurement system, and
a controller which controls movement of the second substance on the second coordinate system according to the first position information and the second position information when the second substance is exposed.

BRIEF DESCRIPTION OF THE DRAWINGS

The above and further objects, features and advantages of the present invention will become more apparent from the following detailed description taken in conjunction with the accompanying drawings, wherein:

FIG.1 is a partially-cutaway configuration view of a projection exposure apparatus according to a first embodiment of the present invention;
FIG.2 is a plan view of a wafer stage system and a wafer loader system that are shown in FIG.1;
FIG.3A is a plan view of a wafer holder 24A and a wafer W1 that are shown in FIG.1;
FIG.3B is a cross-sectional view along the line B-B of FIG.3A;
FIG.4 is a plan view of a wafer stage system of a projection exposure apparatus according to a second embodiment of the present invention;
FIG.5 is a perspective view of the wafer stage system shown in FIG.4;
FIG.6 is a plan view of a wafer stage system and a wafer loader system of a projection exposure apparatus according to a third embodiment of the present invention;
FIG.7A is a plan view of another example wafer according to the embodiments of the present invention;
FIG.7B is a front view of the example wafer shown in FIG.7B; and
FIG.8 is a plan view of a modified example of the wafer shown in FIGS.7A and 7B.

## DESCRIPTION OF THE PREFERRED EMBODIMENTS

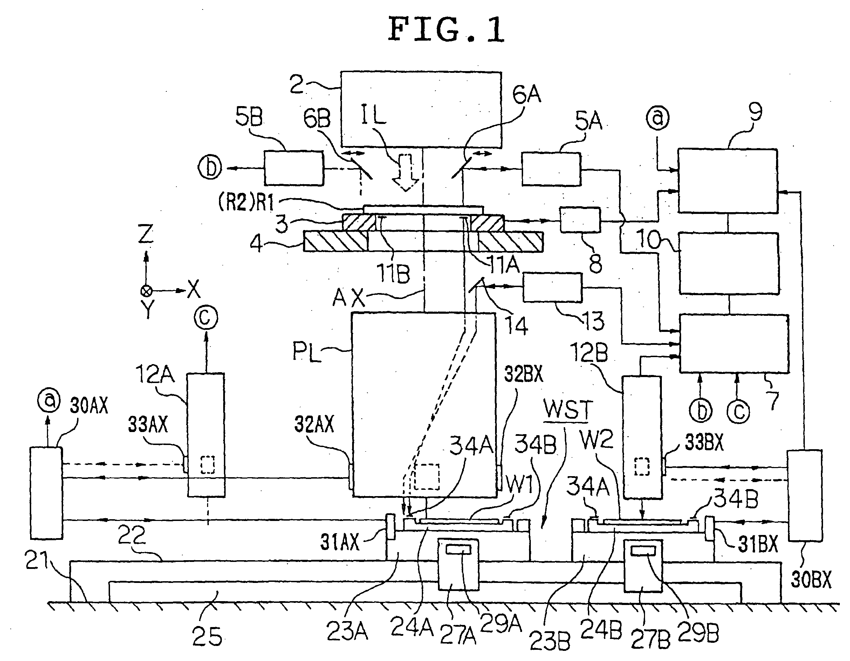

Hereinbelow, a first embodiment of the present invention will be described with reference to FIGS.1 to 3. The first embodiment has a configuration wherein the present invention is applied to a scanning exposure type projection exposure apparatus that employs a step-and-scan method.

FIG.1 shows the configuration of the projection exposure apparatus according to the first embodiment. In FIG.1, an illumination optical system 2 is configured to include an exposure light source, a beam-forming optical system, a luminance-distribution uniforming optical integrator (a uniformizer or a homogenizer), an aperture diaphragm of an illumination system, a relay lens system, a variable view-field aperture diaphragm (reticle blind), and a condenser lens system. At the time of exposure, exposure light IL (exposure beams) led from the illumination optical system 2 illuminates a pattern area of a pattern surface (reticle surface) of a reticle R1 (or a reticle R2) that is used as a mask with a slit-like illumination area. For the exposure light IL, the present embodiment uses an ArF excimer laser (wavelength: 193 nm), of which the oscillatory wavelength band is narrowed. However, the present invention may be applied to cases using vacuum ultraviolet light (wavelength of which is at most 200 nm in the present embodiment),

such as an $F_2$ laser (wavelength: 157 nm), a $Kr_2$ laser (wavelength: 146 nm), and a higher harmonic wave generator of a YAG laser; and a higher harmonic wave generator of a semiconductor laser. In addition, the invention may be applied to a case using far ultraviolet light (wavelength of which is ranged from 200 to 300 nm for the present embodiment) like a KrF excimer laser (wavelength: 248 nm) or ultraviolet light (wavelength of which is about 300 nm), such as g-line and i-line. The illumination optical system may not includes the exposure light source (not shown), and may be comprised of a part of an optical system disposed between the exposure light source and the reticle.

As in the present embodiment, when the vacuum ultraviolet light is used for the exposure beams, it is significantly absorbed by impurities included in the ordinary air, such as oxygen, vapor, hydrocarbon gases (such as carbon dioxide), organic matters, and halides. Therefore, in order to prevent attenuation of the exposure beams, a purging gas is fed to an optical path of the exposure beams. The purging gas is generated through high-level elimination of impurities by using a gas that permits the exposure beams to transmit; that is, the air is purged by using a noble gas, such as a nitrogen ($N_2$) gas, a helium (He) gas, or a neon (Ne) gas.

In FIG.1, with the exposure light IL being used, a pattern image in an illumination area of the reticle R1 (or reticle R2) is projected onto a slit-like exposure area (an area which is coujugate with the illumination area with respect to the projection optical system PL) on a wafer W1 (or W2), on which photoresist is coated so as to be a photosensitive substrate (sensitive substrate or exposure-target substrate), via a projection optical system PL at a magnification factor $\beta$ ($\beta$ represents 1/4, 1/5, or the like). In this state, the reticle R1 and the wafer W1 are synchronously moved in a predetermined scan direction at the magnification factor $\beta$ as a speed ratio to thereby illuminate the pattern area of the reticle R1 with the exposure light and to scan and expose one of the shot areas on the wafer W1 with the expose light IL, thereby transferring a pattern image of the reticle R1 onto the one of the shot areas. The wafer W1,W2 corresponds to a substrate (exposure-target object) in the appended claims of the present invention. It is a disc-like substrate formed of, for example, a semiconductor (silicon or the like) or a SOI (silicon on insulator), to have a diameter of 200mm, 300mm, or the like.

As disclosed in International Patent Publication No.WO00/39623, the projection optical system PL may be formed by using, for example, a cylindrical refraction birefringence system configured by disposing a plurality of refracting lenses along a single optical axis and two convex mirrors each having an opening near the optical axis, and a cylindrical system configured by disposing a plurality of refraction lenses along a single optical axis. In addition, the projection optical system PL may be formed by using, for example, a double-cylindrical refraction birefringence system. Hereinbelow, configurations will be described with reference to a Z-axis, Y-axis, and X-axis defined as follows. The Z-axis is defined to be parallel to an optical axis AX of the projection optical system PL. The Y-axis is defined to be along the scan direction of the reticle R1 and the wafer W1 at the time of scanning exposure within a plane (which is substantially the same as a horizontal plane in the present embodiment) perpendicular to the Z-axis (that is, in the direction perpendicular to the sheet face of FIG.1). The X-axis is assumed along a non-scanning direction (that is, in the direction parallel to the sheet face of FIG.1).

On a reticle base 4 disposed in a portion above the projection optical system PL, a reticle stage 3 is mounted to be continuously movable in the Y direction via an air-bearing and concurrently to be slightly movable in the X direction, the Y direction, and a rotational direction. The reticle R1 is, for example, vacuum-adsorbed and is thereby held on the reticle stage 3. The reticle stage 3 is driven by means of a moving member (not shown) in the Y direction to satisfy the law of conservation of momentum; thereby, almost no vibration occurs during scanning exposure. Another reticle R2 is held in an area adjacent to the scan direction of the reticle R1 on the reticle stage 3 so that, for example, double exposure can efficiently be executed. As described above, the reticle stage 3 of the first embodiment is of a double-holder type. However, the reticles R1,R2 may either be formed by employing either a double-stage type using a movable stage, or a single stage of a single-holder type.

A reticle interferometer 8 having a plurality of axes is disposed. It is formed of a laser interferometer. For example, the reticle interferometer 8 performs measurement according to a reference mirror (not shown) immobilized on an upper peripheral face of the projection optical system PL. The measurement is performed to detect, for example, the position of the reticle stage 3 in the X direction and the Y direction, and the angle of rotation (the amount of yawing) thereof around the Z-axis reticle stage 3. The reticle interferometer 8 feeds the values of the measurement to a stage control system 9. The measurement values are also fed to a primary control system 10 that performs overall control of operation of the apparatus. According to the aforementioned measurement values and control information sent from the primary control system 10, the stage control system 9 controls the operation of the reticle stage 3 via a driving section (not shown), such as a linear electric motor. In the present embodiment, a reticle stage system is configured to include the reticle stage 3, the driving section (not shown), and the reticle interferometer 8.

To allow alignment of the reticle and the wafer to be performed, as alignment marks, plural pairs of reticle marks are formed in such a manner as to sandwich the pattern area of the reticle R1 in the non-scanning direction (X direction), Among the alignment marks, FIG.1 shows a pair of reticle marks 11A and 11B that are formed of two-dimensional marks substantially symmetric with respect the center of the illumination area of exposure light IL. Over the reticle marks 11A and 11B, there are disposed a pair of optical-path bending mirrors 6A and 6B so as to move away from the optical path of the exposure light IL. In a manner as to oppose the mirrors 6A and 6B, there are disposed reticle alignment microscopes 5A and 5B, respectively, to be used as alignment sensors of a TTR (through the reticle) type (the alignment microscope 5A, 5B will be referred to as an "RA microscope", hereinbelow).

At the time of exposure, the mirror 6A, 6B is moved away from the optical path of the exposure light IL. At the time of alignment, the mirrors 6A and 6B are set over the reticle marks 11A and 11B, respectively. Via the mirror 6A, the RA microscope 5A on one side transmits alignment light having the same wavelength as that of the exposure light IL to illuminate the reticle mark 11B. The alignment light transmitted around the reticle mark 11A illuminates a detection-target mark on the image-field side via the projection optical system PL. Light reflected from the detection-target mark returns to the RA microscope 5A via the projection optical system PL, the reticle R1, and the mirror 6A. Light reflected from the reticle mark 11A returns to the RA microscope 5A via the mirror 6A. An imaging optical system forms an overlapped image of the detection-target mark and the reticle mark 11A. The overlapped image is photoelectrically converted by a photographing device to thereby produce a photographing signal, and the photographing signal is then fed to an alignment-signal processor system 7. Similarly, using alignment light having the same wavelength as that of the exposure light IL, the RA microscope 5B on the other side forms an overlapped image of the reticle mark 11A and a corresponding detection-target mark. A photographing signal thereby generated is fed to the alignment-signal processor system 7.

In the RA microscope 5A, 5B of the present embodiment, since the light having the same wavelength as that of the exposure light IL is used, chromatic aberration is not caused with the projection optical system PL. Therefore, the reticle surface under the alignment light becomes conjugate with the image field under the exposure light IL of the projection optical system PL. Accordingly, in a case where the detection-target mark is not covered by the photosensitive material (such as the photoresist), the detection-target mark can be set at the same height as that of the image field thereof, and the amount of positional deviation between the reticle mark 11A, 11B and the corresponding detection-target mark can be directly detected at high precision, thereby allowing high-precision alignment to be obtained. For the alignment light having the aforementioned exposure wavelength, part of light separated through a separating optical system may be used. Alternatively, since a high luminance is not required, the light may be obtained by amplifying a semiconductor laser beam through an optical fiber amplifier or the like.

The alignment-signal processor system 7 processes the photographing signal received from the RA microscope 5A, 5B. It converts the amounts of positional deviations in the X and Y directions of the detection-target mark with respect to the reticle mark 11A into values representing the amounts of positional deviations on the image-field side (wafer side) of the projection optical system PL. Similarly, the alignment-signal processor system 7 converts the amounts of positional deviations of the target-mark image in the X and Y directions with respect to the reticle mark 11B into values representing the amounts of positional deviations on the image-field side (wafer side) of the projection optical system PL. The amounts of positional deviations, which have thus been obtained, are then fed to the primary control system 10. Plural pairs of reticle marks are also formed on the second reticle R2. Also in this case, similarly to the case described above, the alignment-signal processor system 7 detects the amounts of positional deviations between the reticle marks and the corresponding detection-target marks.

Between the reticle R1 and the projection optical system PL, there is disposed an optical-path bending mirror 14 at a position slightly spaced away from the optical path of the exposure light IL. In a manner as to oppose the optical-path bending mirror 14, there is disposed an alignment sensor 13 of a TTL (through-the-lens) type and a photographing type. The alignment sensor 13 also radiates alignment light having the same wavelength as that of the exposure light IL to illuminate a detection-target mark provided at the same height as that of the image field of the projection optical system PL via the optical-path bending mirror 14 and the projection optical system PL; and it receives light reflected from the detection-target mark via the projection optical system PL and the mirror 14. Using the reflecting light, an image of the detection-target mark is formed over an index mark board in the alignment sensor 13. On the index mark board, there is formed an index mark, which is used as a two-dimensional positional reference. Light is transmitted thorough the index mark board, and thereby forms an overlapped image of the index mark and the detection-target mark over the photographing device. A photographing signal of the photographing device is fed to the alignment-signal processor system 7. In response, the alignment-signal processor system 7 processes the photographing signal to convert the amounts of positional deviations of the target-mark image with respect to the aforementioned index mark into values representing the amounts of positional deviations on the image field of the projection optical system PL. Then, the alignment-signal processor system 7 feeds the amounts of positional deviations to the primary control system 10.

In the above case, a point on the image field of the projection optical system PL, which is conjugate with the center of the index mark in the alignment sensor 13, is the detection center of the alignment sensor 13.

Measurement is performed for spaces in the X and Y directions between the detection center and the center (exposure center) of a projection image in the pattern of the reticle R1 (or R2), the aforementioned spaces being hereinbelow referred to as a baseline BX1 in the X direction and the baseline BY1. The measurement results are stored in storage in the primary control system 10. The baselines BX1 and BY1 of the TTL-type alignment sensor 13 is short, for example, to such an extent as the width of one of the shot areas on the exposure-target wafer. Therefore, variations of the baselines BX1 and BY1 can be disregarded. In addition, the alignment sensor 13 uses the alignment light having the exposure wavelength to detect the detection-target mark via the projection optical system. Therefore, even in the case where the detection-target mark is not covered by the photosensitive material (such as the photoresist), the position of the detection-target mark can be detected stably at high precision. This allows high alignment precision to be obtained.

The configuration described above may be modified such that the alignment sensor 13 is used as a Y-axis sensor dedicated for detecting the position of the detection-target mark in the Y direction, and an X-axis TTL-type alignment sensor dedicated for detecting the position of the detection-target mark in the X direction is disposed at a position where the alignment sensor 13 is rotated by 90 degrees around the projection optical system PL (optical axis AX). The X-axis and Y-axis alignment sensors disposed as described above allow the X-axis and Y-axis baselines to be substantially zero, thereby further improving the alignment precision.

The above-described TTR-type microscopes 5A, 5B and TTL-type alignment sensor 13 correspond to a second mark-detecting system in the appended claims of the present invention. For example, suppose the projection optical system PL is configured such that the alignment light can be easily led to be incident upon and can be easily taken out when the projection optical system PL is placed at an intermediate position (for example, the vicinity of a pupil plane). This configuration, instead of the alignment sensor 13 may include an alignment sensor for detecting the position of the detection-target marks through part of optical system that constitutes the projection optical system PL. It is needless to say that the second mark-detecting system may comprise only either one of an alignment sensor of the TTR-type and an alignment sensor of the TTL-type.

For the TTR-type microscope 5A, 5B and the TTL-type alignment sensor 13, a sensor of a type different from the photographing type may be used. One of usable sensors is of a laser step alignment type (LSA type) as is disclosed in Japanese Unexamined Patent Application Publication No.6-16478(1994) and corresponding United States Patent No.4,677,301, wherein it is controlled to perform relative scanning of slit-like optical beams and dot-matrix marks. Another one of usable sensors is, as is disclosed in Japanese Patent No.

2814520 and corresponding United states Patent No. 5,489,986, either of a two-beam-flux interference type for detecting plural fluxes of interference light of diffraction light generated from diffraction-matrix marks; or of a LIA (laser interferometric alignment) type.

Still another one of usable sensors is of a type that radiates alignment light to illuminate a diffraction matrix mark substantially perpendicular thereto, that causes beams of diffraction light, which are generated from the marks and have the same orders (for example, ±1 order, ±3 order, ... , etc.), to interfere with each other, and that thereby detects the marks. Still another one of usable sensors is of a type that causes plural beams of diffraction light, which are obtained by radiating diffraction light generated from the aforementioned mark to illuminate a different mark (which is a reticle mark or an index mark when the aforementioned mark is a wafer mark) , to interfere with each other to thereby detect the marks. For the alignment light, the alignment sensor of the TTR-type or the TTL-type (second mask-detecting system) may use light having a wavelength different from that of the exposure light IL, for example, single-wavelength light in an infrared-ray band or a visible band. In this case, chromatic aberration of the projection optical system PL can occur under the aforementioned exposure light. To offset or reduce the chromatic aberration, for example, an aberration-correcting element (such as a diffraction optical element) is preferably disposed on the optical path of the alignment light.

In addition, in the configuration of the embodiment, alignment sensors 12A and 12B of an off-the-axis and photographing type (FIA (field image alignment) type) are disposed such as to sandwich the projection optical system PL. The alignment sensor 12A, 12B corresponds to a first mark-detecting system in the appended claims of the present invention. It radiates alignment light having, for example, a wide-band wavelength that is different from an exposure wavelength of a halogen lamp or the like, and thereby illuminates the detection-target mark. Then, it receives light reflected from the detection-target mark, and thereby forms an image of the detection-target mark on an interior index mark board. On the index mark board, there is formed an index mark used as a two-dimensional positional reference; and light transmitted through the index mark board forms an overlapped image of the index mark and the detection-target mark on a photographing device. A photographing signal generated on the photographing device is fed to the alignment-signal processor system 7. Then, the alignment-signal processor system 7 processes the photographing signal to converts the amounts of positional deviations with respect to the index mark in the alignment sensor 12A (or 12B) into values representing the amounts of positional deviations, and feeds the amounts of positional deviations to the primary control system 10.

Furthermore, each of the alignment sensors 12A and 12B has a built-in an autofocus mechanism used for optically detecting the amount of defocus from the best focal position of the target field. The information of the amount of the defocus thereby detected is fed to the primary control system 10 via the alignment-signal processor system 7. According to the information of the amount of the defocus information, as described below, the primary control system 10 focuses the position of the target field to the best focus position of the alignment sensor 12A, 12B through the stage control system 9 and detects the detection-target mark in that state .

In the above case, the alignment light of the alignment sensor 12A, 12B has the wide-band wavelength different from that of the exposure wavelength. Therefore, even when a photosensitive material applied with a reflection-preventing coating against the exposure wavelength is coated on the detection-target mark or even when the amounts of differences between convex and concave portions (in uneven portions) of the detection-target mark assumes specific values, the amounts of positional deviations in the X and Y directions of the detection-target mark with respect the detection center (a conjugate point on the target field with the center of the index mark in the alignment sensor 12A, 12B) can be stably detected at high precision. For the off-the-axis type alignment sensor 12A, 12B, a sensor of a LSA type, a LIA type, or the like may be used instead of the sensor of the photographing type . In this case, the sensor may use either alignment light that has a single wavelength that is different from the exposure wavelength or light having multi-wavelength that is different from the exposure wavelength.

Hereinbelow, a description will be made regarding a wafer stage system of the projection exposure apparatus according to the present invention.

As shown in FIG.1, an upper face of a wafer base 22 immobilized on a level block 21 is finished to have a significantly high flatness to work as a guide face. On the guide face, a first wafer stage 23A and a second wafer stage 23B are mounted to serve as movable stages. Via an air-bearing, the wafer stage 23A, 23B is disposed to be slidable smoothly and two-dimensionally along an X-axis guide 25 and a Y-axis guide 29A, 29B. A wafer holder 24A is immobilized on the upper face of the first wafer stage 23A, and a first wafer W1 is held on the wafer holder 24A in such a manner as to be vacuum adsorbed. In the present embodiment, peripheral portions of the wafer holder 24A are set to the same height as that of the surface (wafer surface) of the first wafer W1. On the aforementioned peripheral portions , there are formed reference marks 34A and 34B and the like (which will be described below in detail). Similarly, a second wafer W2 is held on an upper surface of the second wafer stage 23B via a second wafer holder 24B; and reference marks 34A and 34B and the like are formed in areas set to the same height as that of a wafer surface in the peripheral portion of the second wafer holder 24B. The wafer holders 24A and 24B correspond to holding members for holding the substrates (exposure-target objects) in the appended claims of the present invention.

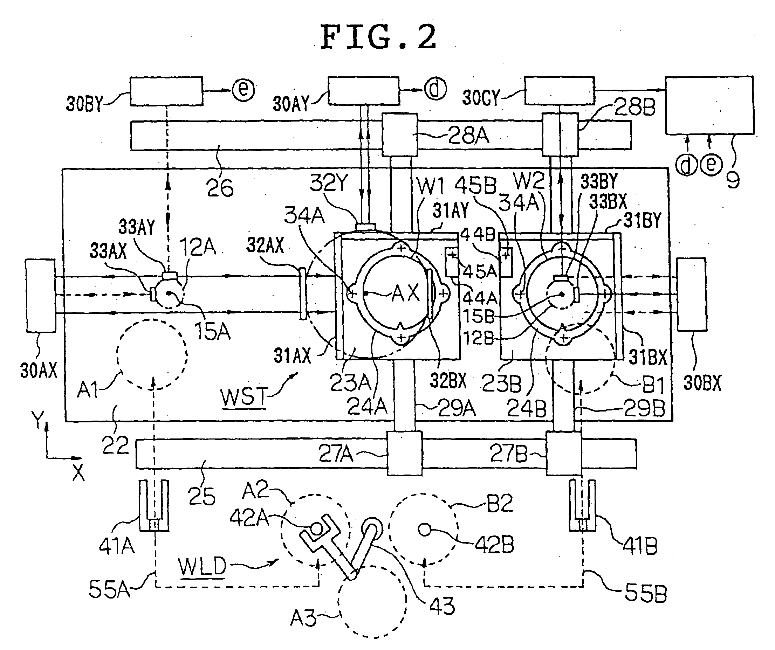

FIG.2 is a plan view of the wafer stage system shown in FIG.1. In FIG.2, a pair of X-axis guides 25 and 26 are disposed such as to sandwich the wafer base 22 in the scan direction (Y direction) and in such a manner as to be parallel to the X-axis at the time of scanning exposure. On the X-axis guides 25 and 26, first X-axis sliders 27A and 28A are disposed to be slidable in the X direction via air-pads; and similarly, second X-axis sliders 27B and 28B are disposed.

For the first X-axis sliders 27A and 28A, a Y-axis guide 29A is disposed to be slidable via air-pads in the Y direction . Similarly, for the second X-axis sliders 27B and 28B, a Y-axis guide 29B is disposed to be slidable in air-pads in the Y direction. The wafer stages 23A and 23B are disposed to be slidable on the Y-axis guides 29A and 29B, respectively, via air-pads in the Y direction. X-direction first and second linear motors (not shown) are disposed, respectively, for relatively driving the first X-axis sliders 27A and 28A and the second X-axis sliders 27B and 28B on the X-axis guides 25 and 26, substantially satisfying the law of conservation of momentum. Two linear motors (not shown) are disposed, respectively, for relatively driving the wafer stages 23A and 23B in the Y direction of the Y-axis guides 29A and 29B, substantially satisfying the law of conservation of momentum.

The wafer stage 23A, 23B continuously moves in the Y direction by the method of the linier motor. In this case, according to the reverse movement of the X-axis guides 25 and 26 and the Y-axis guides 29A and 29B, the respective wafer stage 23A and 23B are driven to substantially satisfy the law of conservation of momentum in the X and Y directions. Therefore, in the above-described configuration, almost no vibrations are caused at the time of scanning exposure.

On an upper surface in a +X direction of the first wafer stage 23A, a reference mark member 44A is immobilized. A reference mark 45A and the like for checking the baseline in the alignment sensor 13 shown in FIG.1 are formed on the reference mark member 44A. Similarly, the reference mark 45B that is identical to the reference mark 45A is formed on a reference mark member 44B, and the reference mark member 44B is immobilized on an upper surface of the second wafer stage 23B.

Reference is made again to FIG.1. A Z-leveling mechanism (sample table) in the wafer stage 23A, 23B is configured so as to be displaced in a Z direction of the wafer W1,W2 and so as to be slanted about two axes (that is, about the X-axis and Y-axis) in order to perform focusing and leveling. In this case, an unillustrated multipoint-autofocus sensor (AF sensor) of a grazing-incidence type is disposed to measure focal positions (positions in the Z direction) at a plurality of measurement points that are set only in the exposure area of the projection optical system PL or that are set in the exposure area as well as in an outer area of the exposure area. According to measurement values that have been output from the AF sensor, either the surface of the wafer W1, W2 or the target field in an outer peripheral portion of the wafer holder 24A, 24B can be focused according to an autofocus method onto the best focal position (image field) of the projection optical system PL.

As shown in FIG.1, in order to detect position information in the X direction of the wafer stages 23A and 23B, X-direction wafer interferometers 30AX and 30BX each formed of a laser interferometer are disposed to oppose each other. In addition, as shown in FIG.2, in order to detect position information in the Y direction of the wafer stages 23A and 23B, three Y-direction wafer interferometers 30BY, 30AY, and 30CY are disposed. Based on the alignment sensor 12A, 12B or the projection optical system PL as a reference, the individual wafer interferometers 30AX, 30BY, 30BY, 30AY, and 30CY perform measurement to detect the position of the wafer stages 23A and 23B in the X and Y directions, the rotation angles (amounts of pitching) thereof about the X-axis, the rotation angles (amounts of rolling) thereof about the Y-axis, and the rotation angles (amount of yawing) thereof about the Z-axis, and feed resultant measurement values to the stage control system 9. The measurement values are also fed to the primary control system 10. Using control information received from the primary control system 10, the stage control system 9 controls the positions of the wafer stages 23A and 23B and the movement speeds thereof by means of the liner motors (not shown).

The present embodiment comprises a wafer stage system WST of a double wafer stage type. The system WST is configured of a measuring system that comprises the wafer stages 23A and 23B, driving units (such as the X-axis guides 25 and 26 and Y-axis guides 29A and 29B), and the wafer interferometers 30AX, 30BX, and 30AY to 30CY.

Hereinbelow, the configuration of the measuring system in the wafer stage system WST will be described.

In FIG.2, an X-direction movable mirror 31AX (which may be a specular-processed mirror) and a Y-axis movable mirror 31AY are immobilized on peripheral surfaces of the first wafer stage 23A in a -X direction and a +Y direction, respectively. Similarly, an X-axis movable mirror 31BX and a Y-axis movable mirror 31BY are immobilized on peripheral surfaces of the second wafer stage 23B in the +X direction and the +Y direction, respectively. In addition, an X-axis reference mirror 33AX and a Y-axis reference mirror 33AY are immobilized on peripheral surfaces of the one-side alignment sensor 12A in the -X direction and the +Y direction, respectively. Similarly, an X-axis reference mirror 33BX and a Y-axis reference mirror 33BY are immobilized on peripheral surfaces of the other-side alignment sensor 12B in the +X direction and the +Y direction, respectively. In addition, X-axis reference mirrors 32AX and 32BX are immobilized on two peripheral surfaces in the X direction of the projection optical system PL; and on a peripheral surface in the +Y direction thereof, a Y-axis reference mirror 32Y is immobilized. For the mirrors such as the reference mirrors 32AX, 32BX, 33BX, and 33BY, corner-cube reflecting mirrors may be used.

The one-side wafer interferometer 30AX radiates measurement beams of two axes onto the X-axis movable mirror 31AX of the wafer stage 23A in parallel to the X-axis, the two axes being spaced apart form each other at a predetermined distance in the Y direction (a central axis of the two axes passes along the optical axis AX). Also, the wafer interferometer 30AX radiates a reference beam of one axis onto the reference mirror 33AX in such a manner as to pass through a detection center 15A of the alignment sensor 12A. In addition, it radiates reference beams of two axes onto the reference mirror 32AX of the projection optical system PL. At the time of alignment of the wafer W1, the wafer interferometer 30AX performs measurement to detect the position of the wafer stage 23A in the X direction on the basis of the reference mirror 33AX of the alignment sensor 12A as a reference. At the time of exposure of the wafer W1, the wafer interferometer 30AX performs measurement to detect the position of the wafer stage 23A in the X direction on the basis of the reference mirror 32AX of the projection optical system PL as a reference.

In contrast, the other-side wafer interferometer 30BX radiates measurement beams of two axes onto the movable mirror 31BX of the X-axis wafer stage 23B in parallel to the X-axis (a central axis of the two axes also passes along the optical axis AX). Also, the wafer interferometer 30BX radiates a reference beam of one axis onto the reference mirror 33BX in such a manner as to pass through a detection center 15B of the alignment sensor 12B. In addition, it radiates reference beams of two axes onto the reference mirror 32BX of the projection optical system PL. At the time of alignment of the wafer W2, the wafer interferometer 30BX performs measurement to detect the position of the wafer stage 23B in the X direction on the basis of the reference mirror 33BX of the alignment sensor 12B as a reference. At the time of exposure of the wafer W1, the wafer interferometer 30BX performs measurement to detect the position of the wafer stage 23B in the X direction on the basis of the reference mirror 32BX of the projection optical system PL as a reference to. In practice, in addition to the aforementioned measurement beams of two axes, the wafer interferometers 30AX and 30BX radiate measurement beams spaced apart from each other in the Z direction to illuminate the movable mirrors 31AX and 31BX, respectively, to thereby perform measurement to detect the position of the respective wafer stages 23A and 23B in the X direction, the rotation angles (amount of yawing) thereof about the Z-axis, and the rotation angles (amount of rolling) thereof about the Y-axis.

The wafer interferometer 30AY radiates measurement beams of two axes to illuminate the movable mirror 31AY of the wafer stage 23A (or the movable mirror 31BY of the wafer stage 23B) in parallel to the Y-axis (a central axis of the two axes passes along the optical axis AX). Also, the wafer interferometer 30AY radiates a reference beam of two axes to illuminate the Y-axis reference mirror 32Y of the projection optical system PL. At the time of alignment of the wafer W1 or W2, the wafer interferometer 30AY performs measurement to detect the position of wafer stage 23A or 23B in the Y direction on the basis of the projection optical system PL as a reference. When the wafer stage 23A moves to a position below the alignment sensor 12A to perform alignment of the wafer W1, the wafer interferometer 30BY radiates a measurement beam and a reference beam each in parallel to the Y-axis so as to pass through the detection center 15A, and thereby performs measurement to detect the position of the wafer stage 23A in the Y direction on the basis of the alignment sensor 12A as a reference. In contrast, when the wafer stage 23B moves to a position below the alignment sensor 12B to perform alignment of the wafer W2, the wafer interferometer 30CY radiates a measurement beam and a reference beam, each in parallel to the Y-axis, so as to pass through a detection center 15B, and thereby performs measurement to detect the position of the wafer stage 23B in the Y direction on the basis of the alignment sensor 12B as a reference.

In practice, in addition to the aforementioned measurement beams of two axes, the wafer interferometer 30AY radiates measurement beams spaced apart from each other in the Z direction to illuminate the movable mirror 31AY (or 31BY), and thereby performs measurement to detect the position of the wafer stage 23A (or 23B) in the Y direction, the rotation angle (amount of yawing) thereof about the Z-axis, and the rotation angle (amount of pitching) thereof about the X-axis. Thus, the central axis of the measurement beams radiated either from the wafer interferometer 30AX (or 30BX) or the wafer interferometer 30AY, which are used as position measurement systems at the time of exposure of the wafer W1 (or W2), passes along the optical axis AX of the projection optical system PL. Accordingly, on the basis of the projection optical system PL as a reference, the measurement can be performed to detect the positions of the wafers W1 and W2 in a state where no Abbe error is caused, thereby allowing high-precision measurement to be implemented.

Similarly, the central axis of the measurement beams radiated either by the wafer interferometer 30AX (or 30BX) or the wafer interferometer 30BY (or 30CY), which are used as position measurement systems at the time of alignment of the wafer W1 (or W2), passes along the detection center 15A (or 15B) of the alignment sensor 12A (or 12B). Accordingly, on the basis of the alignment sensor 12A, 12B as a reference, the measurement can be performed for the positions of the wafer W1 and W2 in a state where no Abbe error is caused, thereby allowing high-precision measurement to be implemented.

Thus, although the present embodiment uses the different measurement systems for exposure and for alignment, the wafers W1 and W2 are held by the wafer holders 24A and 24B, respectively, on each of which the reference mark is formed. As described below, the configuration avoids the necessity of exchanging high-precision measurement values between the measurement system used for alignment and the measurement system used for exposure. Thereby, the measurement systems can be simplified.

A wafer loader system WLD is disposed in front of the wafer stage system WST of the present embodiment (on the side in a -Y direction). The wafer loader system WLD is configured to include a robot arm 43, delivery axes 42A and 42B, and carrying arms 41A and 41B. The robot arm 43 is rotatable, vertically movable, and extendable; the delivery axes 42A and 42B are each vertically movable; and the carrying arms 41A and 41B each carry a wafer along the transportation channels 55A and 55B, respectively. From the first wafer stage 23A, transportation of wafers to the wafer loader system WLD is performed at a position A1 of an end portion in the -X direction on the wafer base 22. From the second wafer stage 23B, transportation of wafers to the wafer loader system WLD is performed at a position B1 of an end portion in the +X direction on the wafer base 22.

The wafer stage 23A moves to the vicinity of the position A1 to carry a wafer located at a position A3 in a wafer cassette (not shown) or the like to the first wafer stage 23A. After the wafer at the position A3 is carried by the robot arm 43 and paced at a position A2 on the delivery axis 42A, the wafer is carried by the carrying arm 41A along the transportation channel 55A up to the position A1 and is then placed on the wafer holder 24A on the wafer stage 23A. In this case, measurement is performed to detect the center of the wafer and the rotation angle thereof. According to values of the measurement, prealignment is performed so that the wafer will be placed on the wafer holder 24A in predetermined conditions regarding the positions in the X direction and the Y direction and the rotation angle. In addition, an unloading arm (not shown) for holding an exposed wafer is disposed. After the wafer exposed is passed from the unloading arm to the carrying arm 41A, it is guided out from the position A2 to the position A3.

The configuration may be modified such that after either a cutout portion (such as a notch) or a predetermined mark of a preloaded wafer is detected at, for example, the position A1 or a position B1, and at least prealignment for the rotation angle of the wafer is performed, the wafer is transported to the position A1,B1. In addition, in the configuration in FIG.2, although portions of the wafer loader system WLD (the robot arm 43 and the like in the present embodiment) are shared by the wafer stages 23A and 23B, the wafer loader system WLD is not restricted to this configuration. For example, the configuration may be modified such that a wafer loader is provided for each of the wafer stages 23A and 23B.

Similarly to the case of the wafer stage 23A, when a wafer located at the position A3 is guided onto the second wafer stage 23B, the wafer stage 23B moves to the vicinity of the position B1, and the exposed wafer is passed to an unloading arm (not shown). After the wafer located at the position A3 is delivered by the robot arm 43 and placed at a position B2 on the delivery axis 42B, the wafer is carried by the carrying arm 41B along the transportation channel 55B up to the position B1, and is then placed on the wafer holder 24B on the wafer stage 23B. Subsequently, the exposed wafer is returned to the position A3 through a reverse channel. Since the embodiment is of the double wafer stage type, for example, as shown in FIG.2, while the second wafer stage 23B is used, and alignment is thereby performed for the second wafer W2 on the second wafer stage 23B, scanning exposure can concurrently be performed for the wafer W1 on the other-side wafer stage 23A via the projection optical system PL. Thereby, a high throughput can be obtained.

Hereinbelow, a description will be made regarding example operations of alignment and exposure to be performed by the projection exposure apparatus of the present embodiment. Description will start with an explanation of an operation that is performed after a state assumed such that, in FIG.2, the wafer stage 23A moved to the vicinity of the position A1, and the wafer W1 has been unloaded from the wafer loader system WLD onto the wafer holder 24A on the wafer stage 23A.

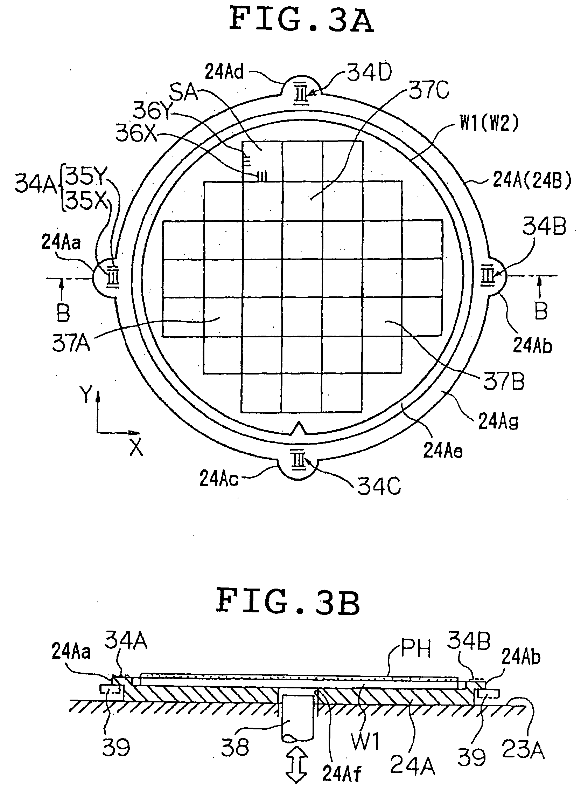

FIG. 3A is a plan view of the wafer W1 on the wafer stage 23A in the aforementioned state; and FIG. 3B is a cross-sectional view along the line B-B of FIG. 3A. In FIGS.3A and 3B, the surface of the wafer W1 is sectioned into a large number of shot areas SA (sectional areas) at predetermined pitches. In each of the shot areas SA, a predetermined circuit pattern, an alignment X-axis wafer mark 36X, and an alignment Y-axis wafer mark 36Y are formed in previous steps. Either the wafer mark 36X or the wafer mark 36Y is of an irregular (convex/concave) pattern of lines and spaces (line-and-space pattern) formed at predetermined pitches in an X direction or a Y direction, respectively. As shown in FIG. 3B, on the surface of the wafer W1, photoresist PH is coated as a photosensitive material to cover all of the shot areas SA, circuit patterns, and wafer marks 36X and 36Y.

The wafer W1 is held in a concave portion 24Ae of the substantially disc-like wafer holder 24A. An upper surface of a ring-like outer peripheral portion 24Ag of the wafer holder 24A is set to substantially the same height of the surface of (wafer surface) of the wafer W1. Semicircular convex portions 24Aa and 24Ab are formed on two end portions in the X direction of the outer peripheral portion 24Ag; and convex portions 24Ac and 24Ad are formed on two end portions of the outer peripheral portion 24Ag. Uniform reference marks 34A, 34B, 34C, and 34D are each formed of a two-dimensional mark on the convex portions 24Aa, 24Ab, 24Ac, and 24Ad, respectively. The reference mark 34A is formed by combination of an X-direction mark 35X and a Y-direction mark 35Y. The X-direction mark 35X is formed of a line-and-space pattern formed in the X direction at predetermined pitches; and the Y-direction mark 35Y is formed of a line-and-space pattern formed in the Y direction at predetermined pitches. However, the reference marks 34A to 34D may be arbitrarily formed. In the present embodiment, the wafer mark 36X,36Y covered by the photoresist corresponds to a first mark in the appended claims of the present invention; and the reference mark 34A, 34B, 34C, 34D formed on the outer peripheral portion 24Ag of the wafer holder 24A, that is, formed in the area not covered by the photoresist (photosensitive material), corresponds to a second mark in the appended claims of the present invention.

Each of the reference mark 34A, 34B, 34C, and 34D may be a one-dimensional mark. In addition, the number of such reference marks is not limited to four, and may be arbitrarily determined depending on the requirement for the precision of alignment.

As shown in FIG.3B, an opening 24Af is formed in a central portion of the wafer holder 24A. An elevation pin 38 extends over from the interior of the wafer stage 23A to be able to move vertically through the opening 24Af and to be rotatable. In the present embodiment, as an example, the wafer holder 24A is immobilized on the upper surface of the wafer stage 23A, and the wafer W1 is vacuum-adsorbed onto the wafer holder 24A through an adsorption opening (not shown). Alternatively, the wafer W1 may be electrostatically attracted thereon.

When the wafer W1 is to be guided in, the wafer W1 is placed over the elevation pin 38, and the elevation pin 38 is then moved down while the rotation angle thereof is corrected. Thereby, the wafer W1 is placed on the wafer holder 24A, and adsorption thereof is started. On the other hand, to carry away the wafer W1, the adsorbing operation is stopped, and the elevation pin 38 is then moved up. Thereby, the wafer W1 is delivered over the elevation pin 38 from the wafer holder 24A.

When, for example, photoresist or the like is adhered onto the wafer holder 24A, the wafer holder 24A is preferably replaced. In this case, to enable the wafer holder 24A to be automatically replaced, the wafer holder 24A may also be immobilized on the wafer stage 23A through either electrostatic attraction or vacuum adsorption. After the adsorption is stopped, as shown by a broken line, an arm 39 is driven in such a manner as to be inserted below a convex portion 24Aa,24Ab, and the arm 39 is moved up to thereby allow the wafer holder 24A itself to be guided away automatically. At this time, a plurality of elevation pins may be provided in addition to the elevation pin 38 to vertically move the wafer holder.

Subsequently, to perform alignment under control of the primary control system 10 shown in FIG. 1, the wafer stage 23A in FIG.1, on which the wafer W1 in the state shown in FIG.3A is placed via the wafer holder 24A, moves below the alignment sensor 12A. Then, the wafer interferometers 30AX and 30BY start measurement to detect the position of the wafer stage 23A on the basis of the alignment sensor 12A as a reference; and position information obtained thereby is fed to the primary control system 10 via the stage control system 9. Subsequently, the alignment sensor 12A and the alignment-signal processor system 7 measure the amounts of positional deviations (amounts of positional deviations with respect to the individual interior index marks) in the X and y directions of the four reference marks 34A to 34D as formed on the wafer holder 24A shown in FIG.3A. Thereafter, they measure the amounts of positional deviations in the X and Y directions of the individual wafer marks 36X and 36Y at least at three shot areas 37A, 37B, and 37C, and feed values of the measurement to the primary control system 10. According to the amounts of positional deviations of each of the aforementioned marks and to the coordinates of the wafer stage 23A at the time of the measurement thereof, the primary control system 10 performs calculation to determine the X-coordinate and the Y-coordinate of each of the marks on a coordinate system that is based on the alignment sensor 12A as a reference.

According to the coordinates of the individual reference marks 34A to 34D on the wafer holder 24A, the primary control system 10 performs calculation by using a least square method to obtain central coordinates (HAX1, HAY1) of the wafer holder 24A and a rotation angle $HA\theta1$ thereof, and determines a coordinate system (HAX, HAY) of the wafer holder 24A rotated by the rotation angle $HA\theta1$ on the origin of the central coordinates. Then, the primary control system 10 converts the coordinates of the wafer marks 36X and 36Y of the three shot areas 37A to 37C formed on the wafer W1 into coordinates in the coordinate system (HAX, HAY) of the wafer holder 24A. Then, as is disclosed in, for example, Japanese Unexamined Patent Application Publication No.4-47968 and corresponding United Stetes Patent No.4,780,617, the disclosures of which are herein incorporated by reference, the primary control system 10 determines array coordinates (XAi, YAi) (i = i, 2, ...) of an i-th shot area SA by using statistical-processing model expressions of an enhanced global alignment (EGA) method.

For the convenience of explaining examples of the model expressions, known design array coordinates of the i-th shot area (i = 1, 2, 3, ...) are assumed to be (XDi, YDi), and calculation array coordinates are assumed to be the aforementioned (XAi, YAi). Also, EGA parameters are assumed to be six error parameters made of offsets (Ox, Oy), scaling (rx, ry), a rotation $\theta$ (rotation error), and orthogonality error $\omega$. In this case, the calculation array coordinates (XAi, YAi) are expressed by the following model expressions:

$$XAi = rx \cdot XDi\text{-}rx\ (\omega+\theta) \cdot YDi\text{+}Ox \quad \text{(EGAX)}$$

$$YAi = ry \cdot \theta \cdot XDi\text{+}ry \cdot YD1\text{+}Oy \quad \text{(EGAY)}$$

In this case, according to the coordinates of the wafer, which are measured in the individual shot area, the aforementioned six error parameter values (Ox, Oy, rx, ry, θ, and ω) are determined by a least square method. Subsequently, the error parameters and the design array coordinates are assigned to the model expressions (EGAX and EGAY), thereby performing high-precision calculation of the array coordinates (XAi, YAi).

The array coordinates (XAi, YAi) concurrently represent position information of the individual shot area of the wafer W1 relative with the wafer holder 24A. The array coordinates (XAi, YAi) are stored in the storage in the primary control system 10.

In the present embodiment, the rotation error (angle HAθ1) of the wafer holder 24A with respect to the X-axis and the Y-axis is to remain as a precondition. Therefore, the coordinate system (HAX, HAY) is to rotate with respect to the X-axis and the Y-axis.

In this case, since the alignment sensor 12A uses alignment light having a wide-band exposure-light wavelength, the reference marks 34A to 34D and the wafer marks 36X and 36Y are all measured at high precision. To quickly perform measurement to detect the center and the rotation angle of the wafer holder 24A, measurement may be carried out only for at least one of the reference marks and for one of the X-axis mark or the Y-axis mark in another one of the reference marks for the two-dimensional reference marks 34A to 34D. However, when the number of the reference marks to be measured is increased, proportionally higher effects in uniformity can be obtained. In addition, since the scaling of the wafer holder 24A can be taken into account, proportionally higher precision can be obtained. Similarly, also for the wafer marks 36X and 36Y, in a minimum case, it is sufficient to perform measurement of only three first-dimensional wafer marks. However, to allow scaling (in the X and Y directions), orthogonality errors, and the like to be taken into account, the measuring method is preferably arranged such that, for example, at least three shot areas are measured, and at least six wafer marks are measured as first-dimensional wafer marks. Alternatively, the mark configuration may be established such that two-dimensional marks are used as the wafer marks (the same configuration as that in FIG. 3A for an example), wherein at least one of the two-dimensional wafer marks is provided in each of the shot areas.

Subsequently, to perform exposure of the wafer under the control of the primary control system 10, as shown in FIG. 2, the wafer stage 23A moves below the projection optical system PL. Thereby, the wafer interferometers 30AX and 30AY start measurement to detect the position of the wafer stage 23A on the basis of the projection optical system PL as a reference. Position information obtained through the measurement is fed to the primary control system 10 via the stage control system 9. For example, as shown in FIG.1, in a state where the reticle stage 3 is positioned so that the center of the pattern area of the reticle R1 substantially is aligned with the optical axis AX, the reference mark 34A on the wafer holder 24A is positioned so that the reference mark 34A on the wafer holder 24A is moved to a position substantially conjugate with the reticle mark 11A.

To achieve the above, for example, in FIG.2, the space between the detection center 15A and the optical axis AX is predetermined; and when the wafer stage 23A is moved from a position below the alignment sensor 12A to a position below the projection optical system PL, measurement is performed to detect the position in the X direction on the bases of the alignment sensor 12A. Concurrently, in an area wherein measurement is not performed for the value of the Y-axis at the time when the wafer interferometer is switched from the wafer interferometer 30BY to the wafer interferometer 30AY, the wafer stage 23A is driven in the X direction in a state where the wafer stage 23A is controlled to be static with respect to the Y-axis guide 29A. After the reference mark 34A is moved into an observational view field of the RA microscope 5A, the wafer interferometers 30AX and 30AY are then controlled to perform measurement to detect the position of the wafer stage 23A on the basis of the projection optical system PL as a reference.

Subsequently, as shown in FIG. 1, the mirror 6A is moved onto the reticle mark 11A, alignment light having the exposure wavelength from the RA microscope 5A is led to illuminate the reticle mark 11A, and the alignment light passed around the reticle mark 11A is then led to illuminate the reference mark 34A. Subsequently, the alignment-signal processor system 7 is controlled to measure the amounts of positional deviations (ΔXA1, ΔYA1) in the X and Y directions of the reference mark 34A with respect to the image of the reticle mark 11A, and to feed values of the measurement and the coordinates of the wafer stage 23A at the time of the measurement to the primary control system 10. Subsequently, the wafer stage 23A is driven so that the reference mark 34B on the wafer holder 24A moves to a position substantially conjugate with the other-side reticle mark 11B. Then, the other-side RA microscope 5B is controlled to measure the amounts of positional deviations (ΔXB1, ΔYB1) in the X and Y directions of the reference mark 34B with respect to the image of the reticle mark 11B, and to feed values of the measurement and the coordinates of the wafer stage 23A at the time of the measurement the primary control system 10.

In the above, the center of the image of the reticle mark 11A, 11B is the exposure center, and the tilt angle of a straight line extending through the center thereof with respect to the X-axis represents a tilt angle RAθ1 of the reticle pattern image. In this case, the rotation angle of the reticle stage 3 is preliminarily corrected so that the tilt angle RAθ1 becomes zero. Then, the primary control system 10 performs calculation to determine the X-coordinate and the Y-coordinate of the reference mark 34A, 34B on a coordinate system (PLX, PLY) having the origin representing the exposure center. Similarly, the reference marks 34C and 34D are serially moved to a position conjugate with the reticle mark 11A, 11B; and the microscope 5A, 5B is controlled to perform calculation to determine the X-coordinate and the Y-coordinate of the reference mark 34C,34D on the coordinate system having the origin representing the exposure center.

Subsequently, the primary control system 10 uses the X-coordinate and the Y-coordinate of the individual reference marks 34A to 34D, and thereby performs calculation to detects offsets (ΔX2, ΔY2) in the X direction and the Y direction of the coordinate system (HAX, HAY) on the basis of the individual reference marks 34A to 34D and a rotation angle HAθ2 of the wafer holder 24A with respect to the coordinate system (PLX, PLY) having the origin representing the exposure center. Then, the primary control system 10 uses the information of offsets (ΔX2, ΔY2) and the rotation angle HAθ2 and the array coordinates (XAi, YAi) of the individual shot area of the wafer W1 on the coordinate system (HAX, HAY) of the wafer holder 24A, the array coordinates (XAi, YAi) being stored in the above-described step. Thereby, the primary control system 10 performs calculation to obtain array coordinates (Xi, Yi) (i = 1, 2, ...) of the individual shot area of the wafer W1 in the coordinate system (PLX, PLY) having the origin representing the exposure center. When the array coordinates (Xi, Yi) are used, the center of the individual shot area SA on the wafer W1 shown in FIG.3A can be aligned with the center of the pattern image of the reticle R1 in FIG.1 at high precision. Subsequently, the optical-path bending mirror 6A, 6B is moved away from the optical path of the exposure light IL, and exposure is thereby performed.

Description has been made in the above such that the four reference marks reference marks 34A to 34D can be detected by using the RA microscope 5A, 5B. However, in the present embodiment, detection of only two reference marks still enables the aforementioned offsets (ΔX2, ΔY2) and rotation angle HAθ2 to be detected. In addition, instead of performing the calculation to detect both the offsets and rotation angle, only the calculation for the offsets is still effective. In this case, it is sufficient to detect at least one of the reference marks through the microscope 5A, 5B.

In addition, instead of the manner of performing calculation to detect only the offsets or both the offsets and the rotation angle, the following alternative manner is also effective. One of the microscopes 5A and 5B is controlled to detect at least three of the reference marks to thereby obtain the X-coordinate and Y-coordinate of the wafer stage 23A (reference marks) on the coordinate system (PLX, PLY) in a state where the amounts of positional deviations of the individual reference mark with respect to the reticle mark are either zeros or predetermined values . Then, for example, the above-described EGA method is applied to perform calculation to determine the array coordinates (Xi, Yi) of the individual shot area. Specifically, in units of the reference marks, the coordinate values on the coordinate system (PLX, PLY) and the coordinate values on the coordinate system (HAX, HAY) for which measurement has precedently been performed are assigned to model expressions of the EGA method, and the error parameters thereof may be obtained through a least square method. Then, the array coordinates (Xi, Yi) of the individual shot area on the coordinate system (PLX, PLY) may be obtained by assigning the array coordinates (XAi, YAi) of the individual shot area on the precedently determined coordinate system (HAX, HAY) to model expressions through which the error parameters have been calculated.

The model expressions to be used for determining the array coordinates (Xi, Yi) may be the same as the model expressions (EGAX and EGAY) used for determining the array coordinates (XAi, YAi). Alternatively, they may be different therefrom such that at least either the numbers or the types of the error parameters (such as the offsets, rotation error, scaling, and orthogonality error) are made different. For example, the model expressions to be used for determining the array coordinates (Xi, Yi) may be determined based on only the offsets and rotation error as the error parameters. The model expressions correspond to model expressions wherein either the scaling rx or ry is set to 1, and the orthogonality error ω is set 0.

In addition, according to the above description, for the coordinate values of the reference mark on the coordinate system (HAX, HAY), measurement values obtained by the off-the-axis type alignment sensor 12A are used for the calculation of the error parameters in the model expressions used to determine the array coordinates (Xi, Yi). However, coordinate values (calculated values) obtained through the model expressions used to determine the array coordinates (XAi, YAi) may be used.

Since the present embodiment is of the scanning-exposure type, relative to a state where the reticle pattern image is virtually aligned with the center of the individual shot area on the wafer W1, the reticle stage 3 and the wafer stage 23A move by a distance at the relative ratio of a projection magnification factor. In a manner to maintain the above relationship, the primary control system 10 controls the reticle stage 3 and the wafer stage 23A to be driven via the stage control system 9, and concurrently, controls the exposure light IL to be radiated. Thereby, the pattern image of the reticle R1 is serially transferred onto the individual shot areas on the wafer W1.

In the above case, in the present embodiment , the marks to be measured by the TTR-type microscopes 5A and 5B are the reference marks 34A to 34D on the wafer holder 24A, which are not covered by a photoresist film. Therefore, significantly high measurement precision can be obtained. In addition, also the array coordinates (XAi, YAi) of the individual shot areas of the wafer W1 on the coordinate system (HAX, HAY) using the reference marks 34A to 34D of the wafer holder 24A as references are subjected to the high-precision measurement and calculation. Therefore, finally, the individual shot area on the wafer W1 can be overlapped at high precision with the pattern image on the reticle R1. That is, high alignment precision (overlapping precision) can be obtained.

In addition, the reference marks 34A to 34D and the wafer mark are also respectively formed on the wafer holder 24B on the second wafer stage 23B of the present embodiment and the wafer W2, as shown in FIG.3A. As shown in FIG.1, during exposure on the wafer W1 on the first wafer stage 23A, alignment is performed for the second wafer W2 on the second wafer stage 23B by using the alignment sensor 12B. Subsequently, the wafer stage 23A is moved to the vicinity of the position A1 shown in FIG.2, and the wafer is replaced with a new wafer. Then, alignment of the new wafer is performed, and concurrently, the second wafer stage 23B is moved below the projection optical system PL, and exposure is performed for the second wafer W2. Thereafter, alignment and scanning exposure or wafers on the wafer stages 23A and 23B are alternately performed, producing high throughputs.

Similarly, when exposure is performed for the pattern of the reticle R2, the RA microscope 5A, 5B is controlled to detect the reticle marks on the reticle R2 and the reference marks 34A to 34D on the wafer holder 24A, 24B. Thereby, high alignment precision can be obtained.

As described above, in the present embodiment, the TTR-type microscopes 5A and 5B are used to detect the reference marks 34A to 34D on the respective wafer holders 24A and 24B. However, the TTL-type alignment sensor 13 may instead be used. When the alignment sensor 13 is used, the baseline, which is the space between the detection center of the alignment sensor 13 and the center of the pattern image of the reticle R1, R2 (the center of the reticle mark 11A, 11B in the present embodiment), needs to be premeasured.

In addition, when the wafer stage 23A is moved from a position below the alignment sensor 12A to a position below the projection optical system PL, it is preferable that the relative positional relationship between the wafer holder 24A and the wafer W1 does not vary as much as possible. For this reason, a temperature control unit constituted to include a heating/cooling device, such as a Peltier device, and a temperature-measuring device, such as a thermistor, may be provided in a portion where the wafer holder 24A of the wafer stage 23A is disposed to thereby maintain the temperatures of the wafer holder 24A the wafer W1 to be unchanged. This can also be applied to the side of the second wafer stage 23B.

In addition, in the present embodiment, the coordinate system (HAX, HAY) of the wafer holder 24A is determined from the coordinate values (measurement values) obtained by detecting the plurality of reference marks. However, the coordinate system (HAX, HAY) may instead be determined by one of the following two manners. In one of the two manners, the plurality of coordinate values obtained as described above are used in calculation according to, for example, the EGA method, to obtain coordinate values of the individual reference mark; and the coordinate system (HAX, HAY) is determined from values obtained through the calculation. In the other way, the coordinate system (HAX, HAY) is determined from parameters, for example, offsets and rotation errors, that are obtained at the time of the calculation of the error parameters of the model expressions used for the calculation performed according to the EGA method to obtain the coordinate values. In addition, the above-described array coordinates (Xi, Yi) may be determined in the following manner. By using coordinate values that can be obtained by detecting at least one of the reference marks through the off-the-axis type alignment sensor 12A, 12B, and coordinate values that can be obtained by detecting wafer marks in at least three shot areas, calculation is performed according to the EGA method to obtain coordinate values of the reference marks and the individual shot areas. Then, according to the deviations between coordinate values obtained by detecting at least one of the reference marks through the microscope 5A, 5B and the coordinate values precedently obtained, the precedently obtained coordinate values of the individual shot areas are corrected to thereby determine the above-described array coordinates (Xi, Yi).

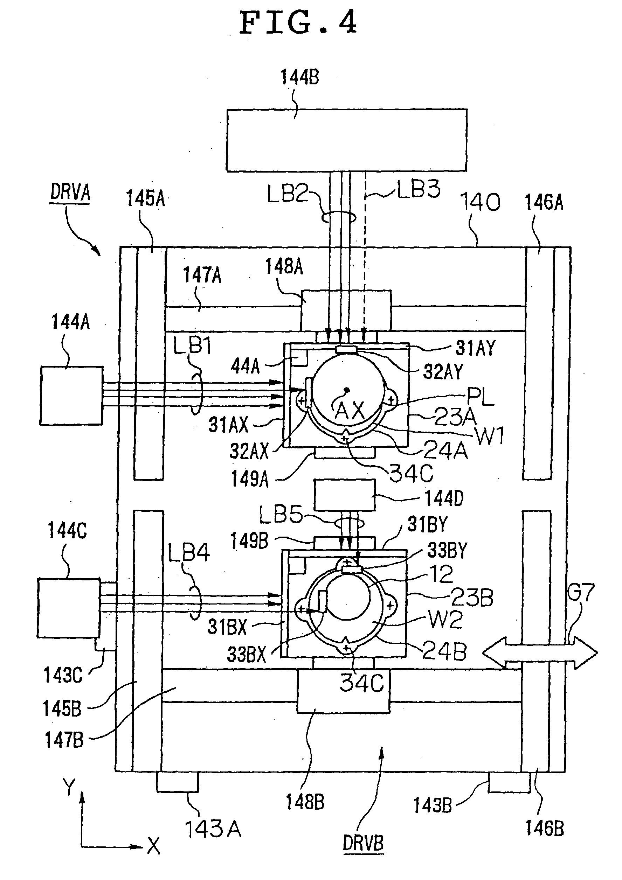

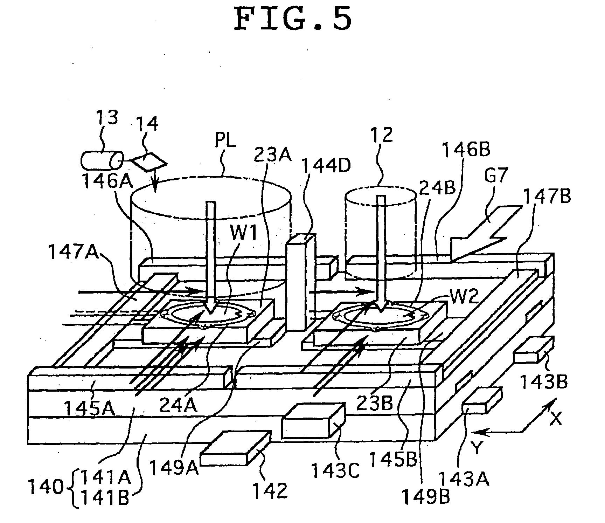

Hereinbelow, a second embodiment of the present invention will be described with reference to FIGS.4 and 5. In FIGS.4 and 5, for portions corresponding to those in FIGS.1, 2, 3A, and 3B, the same reference symbols are used, and detailed descriptions thereof will be omitted herefrom.

FIG.4 is a plan view of a wafer stage system of the second embodiment; and FIG.5 is a perspective view of the wafer stage system shown in FIG.4. As shown in FIG.5, a wafer base 140 is mounted on a level block (not shown). The wafer base 140 is formed of a first movable base 141A and a second movable base 141B that are stacked thereon. On the wafer base 140, movable exchange tables 149A and 149B are each disposed parallel thereto via an air bearing to be slidable in the X direction and the Y direction. Wafer stages 23A and 23B are immobilized on the movable exchange tables 149A and 149B, respectively. Wafers W1 and W2 are held on the wafer stages 23A and 23B via wafer holders 24A and 24B, respectively; and reference marks are formed on outer peripheral portions of the wafer holders 24A and 24B. The wafer stage 23A, 23B of the present embodiment is equivalent to the wafer stage 23A, 23B in FIG.1, wherefrom the Y-direction driving mechanism is removed; and they have focusing and leveling functions. A projection optical system PL having a TTL-type alignment sensor 13 is disposed on the upper side in the +Y direction thereof; and an alignment sensor 12 of an off-the-axis, photographing type is disposed on the side in the -Y direction thereof.

The second movable base 141B is disposed to be slidable along a guide member 142 in the X direction via an air bearing; and the first movable base 141A is disposed thereon to be slidable in the Y direction via an air bearing. The position in the Y direction of the first movable base 141A is controlled by a linear motor 143C; and similarly, the position in the X direction of the second movable base 141B is controlled by linear motors 143A and 143B. Specifically, the wafer base 140 of the present invention is configured such that, when the movable exchange tables 149A and 149B move in the X direction and in the Y direction, it moves in the reverse direction to satisfy the law of conservation of momentum; and concurrently, the position thereof in the X direction and in the Y direction can be appropriately returned to, for example, the center (neutral position) in its movable range. Thereby, vibrations that can occur are suppressed.

In FIG.4, a first pair of Y-axis guides 145A and 146A are immobilized on the wafer base 140 in close proximity to each other in the Y direction; and in the same manner, a second pair of Y-axis guides 145B and 146B are immobilized thereon, wherein the first and second pairs are spaced at a predetermined distance in the X direction. A first X-axis guide 147A and a second X-axis guide 147B are disposed between the Y-axis guides 145A and 146A and between the Y-axis guides 145B and 146B, respectively, to be driven by liner motor methods in the Y direction. Furthermore, a first X-axis slider 148A and a second X-axis slider 148B are disposed to be driven in the X direction along the first X-axis guide 147A and the second X-axis guide 147B, respectively, to be driven by linear motor methods; and the movable exchange tables 149A and 149B are connected to the X-axis sliders 148A and 148B, respectively. In the second embodiment, the movable exchange tables 149A and 149B can be disconnected from the X-axis sliders 148A and 148B, respectively; and the movable exchange tables 149A and 149B can be connected to the different X-axis sliders 148B and 148A, respectively.

The first Y-axis guides 145A and 146A, the first X-axis guide 147A, and the first X-axis slider 148A constitute a first drive system DRVA. The second Y-axis guides 145B and 146B, the second X-axis guide 147B, and the second X-axis slider 148B constitute a second drive system DRVB. The first movable exchange table 149A (wafer stage 23A) and the second movable exchange table 149B (second wafer stage 23B) are exchanged with each other, and are driven by the first drive system DRVA or the second drive system DRVB in the X direction, the Y direction, and the rotational direction. In this case, the first drive system DRVA drives the wafer stage 23A, 23B in a position below the projection optical system PL; and the second drive system DRVB drives the wafer stage 23A, 23B in a position below the alignment sensor 12.

In addition, in the second embodiment, two X-axis wafer interferometers 144A and 144C and two Y-axis wafer interferometers 144B and 144D, each of which is of a laser interferometer, are provided for performing positional measurement of the wafer stages 23A and 23B. Each of the X-axis wafer interferometers 144A and 144C supplies measurement beams LB1 of plural axes along the X-axis for an optical axis AX of the projection optical system PL as their center; and it also supplies measurement beams LB4 of plural axes along the X-axis for an a detection center of the alignment sensor 12 as their center. In the state shown in FIG.4, the laser beams of three axes among the measurement beams LB1 are led to illuminate an X-axis movable mirror 31AX of the wafer stage 23A, and the laser beam of one axis is led to illuminate a reference mirror 32AX of the projection optical system PL. Thereby, measurement is performed on the basis of the projection optical system PL as a reference to detect the position of the wafer stage 23A in the X direction, the rotation angle (amount of yawing) thereof about the Z-axis, and the rotation angle (amount of rolling) thereof about the Y-axis. In addition, the laser beams of two axes among the measurement beams LB4 are led to illuminate an X-axis movable mirror 31BX of the wafer stage 23B, and the laser beam of one axis is led to illuminate a reference mirror 32BX of the alignment sensor 12. Thereby, measurement is performed on the basis of the alignment sensor 12 as a reference to detect the position of the wafer stage 23B in the X direction and the amount of yawing thereof.

In addition, the first Y-axis wafer interferometer 144B supplies measurement beams LB2 of plural axes in the -Y direction along the Y-axis for the optical axis AX of the projection optical system PL as their center. In this connection, as shown by a dotted line together with the measurement beams LB2, it may supply a measurement beam LB3 spaced away from the measurement beams LB2 in the Z direction. In the state shown in FIG.4, the laser beams of two axes among the measurement beams LB2 are led to illuminate a Y-axis movable mirror 31AY of the wafer stage 23A, and the laser beam of one axis is led to illuminate a reference mirror 32AY of the projection optical system PL. Thereby, measurement is performed on the basis of the projection optical system PL as a reference to detect the position of the wafer stage 23A in the Y direction and the amount of yawing thereof. In the present embodiment, since the position of incidence of the laser beams on the movable mirror 31AY is set to the same height as that of the surface of the wafer W1, an Abbe error due to pitching is not caused. However, in order to perform positional measurement at even higher precision, it is preferable that the measurement beam LB3 be also supplied to thereby measure the rotation angle (amount of pitching) about the X-axis of the wafer stage 23A.

In parallel to the above-described beams, the second Y-axis wafer interferometer 144D supplies measurement beams LB5 of plural axes in the -Y direction along the Y-axis for the detection center of the alignment sensor 12 as their center. In the state shown in FIG.4, the laser beams of two axes among the measurement beams LB5 are led to illuminate a Y-axis movable mirror 31BY of the wafer stage 2B, and the laser beam of one axis is led to illuminate a reference mirror 32BY of the alignment sensor 12. Thereby, measurement is performed on the basis of the alignment sensor 12 as a reference to detect the position of the wafer stage 23B in the Y direction and the amount of yawing thereof.

In the present embodiment, as described above, the wafer stages 23A and 23B can be connected to the movable exchange tables 149A and 149B, respectively; and in addition, they can be connected to the different movable exchange tables 149B and 149A, respectively. Therefore, even after the exchange, positional measurement is still performed on the basis of either the alignment sensor 12 or the projection optical system PL as a reference. For example, in the present embodiment, in the course wherein the wafer stage 23A moves from a position below the projection optical system PL to a position below the alignment sensor 12, positional measurement of the wafer stage 23A need not be performed. Thereby, the configuration of a position measurement system can be simplified.

In addition, in the present embodiment, a wafer loading position is set to a position in the -Y direction and in the +X direction, which is close to the alignment sensor 12. As shown by an arrow G7, wafers are passed between the wafer stage 23A, 23B at the loading position and a wafer loader system (not shown). That is, in the projection exposure apparatus of the present embodiment, the single loading position is used. Other configurations are the same as those in the first embodiment.

In the second embodiment, while the wafer stage 23A is driven by the first drive system DRVA, and exposure is performed, the second wafer stage 23B is moved by the second drive system DRVA in the +X direction and in the -Y direction to pass wafers in the directions shown by the arrow G7 between the second wafer stage 23B and a wafer loader system (not shown). Subsequently, the second wafer stage 23B is moved to a position below the alignment sensor 12, and the alignment sensor 12 is controlled to perform measurement to detect the positions of, for example, the reference mark 34C on the second wafer holder 24B and a predetermined wafer mark on the second wafer W2. Thereby, calculation is performed to obtain data of the relative positional relationship of the second wafer W2 with the second wafer holder 24B, and the data is stored.

Subsequently, the X-axis guides 147A and 147B are moved to be in proximity to each other, and the wafer stages 23A and 23B are exchanged with each other. Thereafter, the second wafer stage 23B is driven by means of the first drive system DRVA; for example, the TTL-type alignment sensor 13 in FIG.5 is controlled to perform measurement to detect the position of the reference mark 34C or the like on the second wafer holder 24B; the measurement result and the aforementioned stored data of the relative positional relationship are used in calculation; and a position relative to the reticle-pattern image in the individual shot area on the wafer W2 is thereby obtained. Subsequently, scanning exposure is performed for the second wafer W2, wherein wafer replacement and alignment by the alignment sensor 12 are performed on the side of the wafer stage 23A.

In the above, the present embodiment allows the wafer stages 23A and 23B to be driven completely independent of each other in the X and Y directions, respectively, in the state of satisfying the law of conservation of momentum. Therefore, vibrations that can occur are suppressed. In addition, since only the single alignment sensor 12 is used, it can be adjusted quickly. Furthermore, in the present embodiment, the wafer base 140 can be miniaturized, and the footprint (installation area) of the exposure apparatus can be reduced.

Furthermore, in FIG.4, since the first drive system DRVA is dedicated for exposure, it needs to be driven at a higher speed and acceleration, compared to the second drive system DRVB. However, since the second drive system DRVB is dedicated for alignment, the performance thereof can be lowered, compared to the first drive system DRVA. Therefore, a liner motor of which the performance with respect to, for example, the thrust, is lower can be used. Thereby, the power ( amperage ) of the motor can be reduced , and in addition , heat that can be generated therein is reduced.

In FIG.4, although at least a portion of the wafer interferometer 144D is disposed between the alignment sensor 12 and the projection optical system PL, when it causes a problem in the exchange of the wafer stages 23A and 23B, the wafer interferometer 144D may be disposed on the opposite side (on the side in the -Y direction of the second X-axis guide 147B). In this configuration, a movable mirror (reverse face) to be provided on each of the wafer stages 23A and 23B needs to be disposed in such a manner as to form a letter "U". Specifically, a reflecting face extending in the X-axis needs to be formed at each end of the wafer stage 23A, 23B.

In the configuration of the present embodiment, although the wafer stages 23A and 23B are exchanged with each other in units of the entirety, the configuration may be modified to allow them to be exchanged in units of a portion thereof (that is, at least a portion including the wafer stage 23A, 23B). In this configuration, additional exchange mechanisms (for example, robot arms) are disposed.

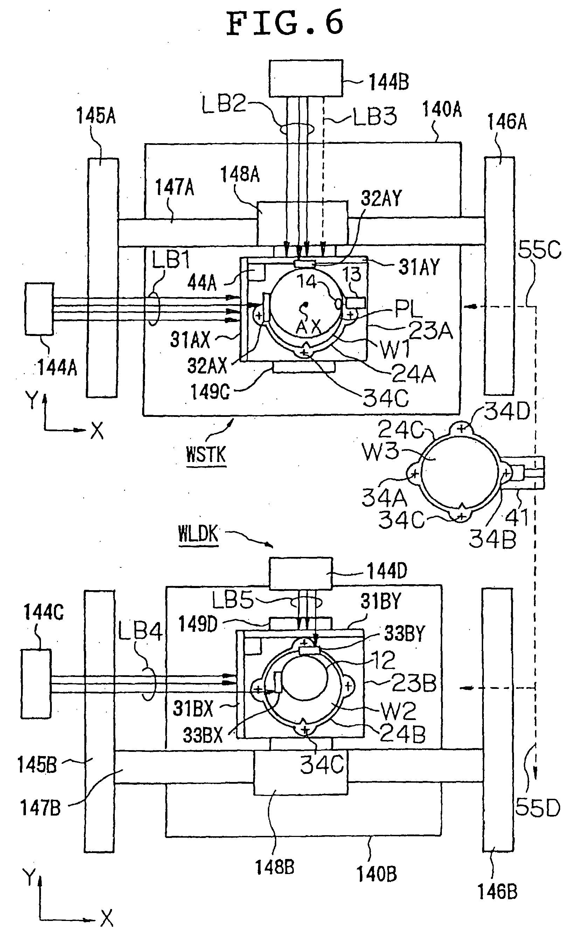

Hereinbelow, a third embodiment of the present invention will be described with reference to FIG.6. The third embodiment is configured such that a wafer holder and a wafer are integrally carried for transportation of wafers. In FIG.6, for portions corresponding to those in FIGS.4 and 5, the same reference symbols are used, and detailed descriptions thereof will be omitted herefrom.

FIG.6 is a plan view of a wafer stage system and a wafer loader system of a projection exposure apparatus according to the present embodiment. In a wafer stage system WSTK shown in FIG.6, a wafer stage 23A is immobilized on a movable table 149C to be driven onto a first wafer base 140A along a guide 145A, 146A and 147A; and a wafer W1 is held on the wafer stage 23A via a wafer holder 24A. Measurement for the position of the wafer stage 23A is performed by wafer interferometers 144A and 144B on the basis of a projection optical system PL as a reference. A reticle stage system that is similar to that of the first embodiment in FIG.1 is disposed on an upper portion of the projection optical system PL.

In a wafer loader system WLDK shown in FIG. 6, a wafer stage 23B is immobilized on a movable table 149D to be driven onto a second wafer base 140B along a guide 145B, 146B and 147B; and a wafer W2 is held on the wafer stage 23B via a wafer holder 24B. Measurement for the position of the wafer stage 23B is performed by wafer interferometers 144C and 144D on the basis of an alignment sensor 12 as a reference. In addition, a carrying arm 41 is disposed for carrying a wafer holder and a wafer in an integrated unit along a transportation channel 55C between a first wafer base 140A and a second wafer base 140B. The carrying arm 41 also has a function for carrying a wafer along a transportation channel 55D from a wafer cassette (not shown). In the state shown in FIG.6, a wafer holder 24C is disposed for holding a wafer W3 onto the carrying arm 41. The reference marks 34A, 34B, 34C, and 34D are formed on wafer holders 24A and 24B, the wafer holder 24C, and a wafer holder 24D.

In the present embodiment, first, an alignment sensor 12 is controlled to perform measurement to detect the positions of the wafer marks, such as the reference mark 34C of the second wafer holder 24B on the wafer stage 23B. Thereby, calculation is performed to obtain data of the relative positional relationship between the second wafer W2 and the wafer holder 24B, and the data is stored. Thereafter, the second wafer holder 24B and the wafer W2 are integrally carried by the carrying arm 41 along the transportation channel 55C, and are then placed on the wafer stage 23A of the wafer stage system WSTK. Subsequently, for example, a TTL-type alignment sensor 13 is controlled to perform measurement to detect the position of the reference mark 34C or the like on the second wafer holder 24B; the measurement result and the relative positional relationship are used in calculation to obtain a position relative to the reticle-pattern image in the individual shot area on the wafer W2; and exposure is performed according to the relative position.

As described above, in the present embodiment, since the wafers W1, W2, and W3 are integrated respectively with the wafer holders 24A, 24B, and 24C and are thereby carried, the wafer stage system WSTK can be miniaturized without causing reduction in the alignment precision. In addition, compared to an exposure time, a time of the alignment using the alignment sensor 12 can be significantly reduced. Therefore, the configuration may be modified such that single wafer loader system WLDK is shared by a plurality of wafer loader systems WLDK. Thereby, the exposure system can be miniaturized overall.

The configuration shown in FIG.6 may be built such that the wafer stage system WSTK and the wafer loader system WLDK are stored in separate chambers, they are inline-connected. Alternatively, it may be built such that the wafer loader system WLDK is separated from the wafer stage system WSTK (exposure apparatus) and is used as a dedicated measurement apparatus; and a wafer holder that holds a wafer by means of for example, an automated guided vehicle (AGV) system or an overhead vehicle (OHV) system is guided from the measurement apparatus to the exposure apparatus.

Furthermore, when the wafer holder 24A, 24B, 24C holding a wafer is exchanged in the present embodiment, or only a portion of the wafer stage 23A, 23B is exchanged, it is preferable that the wafer holder (or a part of the wafer stage) holding a subsequent wafer be guided to the exchange position and held pending thereat until the completion of exposure. In this case, in parallel with carriage of the subsequent wafer, alignment may be started for the further subsequent wafer. In addition, in the embodiment shown in FIG. 6, although the wafer stage system WSTK is arranged to be of the single-stage type is used, it may be arranged to be of a double-stage type as in the first and second embodiments. Thereby, the wafer holder (or, part of the wafer stage) can be replaced on the second wafer stage during exposure of wafers placed on the first wafer stage to thereby improve the throughput. In this case, the alignment sensor of the off-the-axis type need not be provided on the wafer stage system WSTK.

In the embodiment shown in FIG.6, instead of the alignment sensor 13 of the TTL type (or of the TTR type) included in the projection optical system PL, an off-the-axis type alignment sensor may be used.

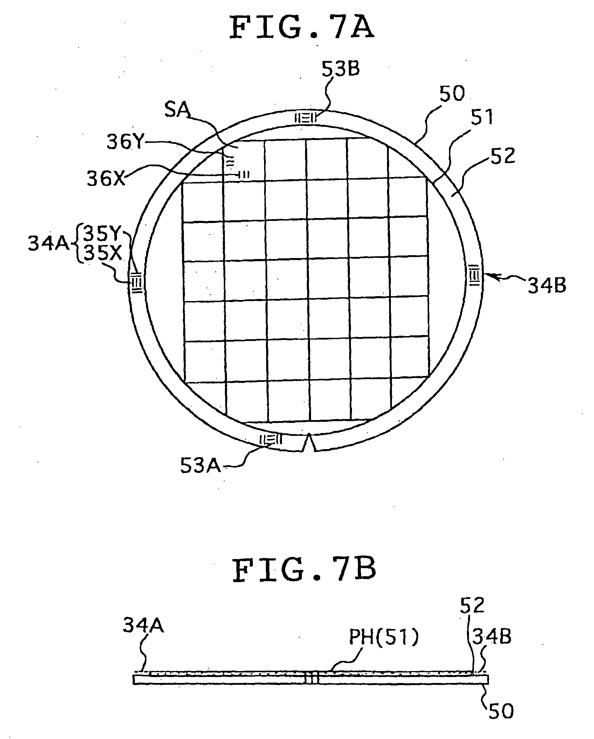

Hereinbelow, another embodiment of the present invention will be described with reference to FIGS.7A and 7B. In this embodiment, instead of forming the reference marks on the wafer holders, the reference marks are formed in areas on a wafer wherefrom the photoresist is removed. For portions corresponding to those in FIG.3, the same reference symbols are used, and detailed descriptions thereof will be omitted herefrom.

FIG.7A is a plan view of an exposure-target wafer 50; and FIG.7B is a front view thereof. In these figures, most part of the wafer 50 is an exposure-target area 51 on which photoresist PH is coated. A ring-state reference area (zero-layer) 52 in a peripheral portion surrounding the exposure-target area 51 is an area from which the photoresist is removed. In the exposure-target area 51, a large number of shot areas SA are formed; and wafer marks 36X and 36Y are covered by the photoresist PH and formed in each of the shot areas SA. In addition, in the reference area 52, there are formed two-dimensional vertically long reference marks 34A and 34B, and two-dimensional horizontally long reference marks 53A and 53B. Among these marks, the reference mark 53A and 53B is formed in such a manner to be away from a notch portion.

The wafer 50 of the present embodiment can be exposed in, for example, the projection exposure apparatus shown in FIG. 1, wherein the wafer holders 24A and 24B are exchanged with ordinary wafer holders having no reference marks. At the time of alignment in the above case, the alignment sensor 12A (or 12B) may be used to perform measurement to detect the positions of the reference marks 34A, 34B, 53A, and 53B; and at the time of exposure, the TTL-type microscopes 5A and 5B may be used to perform measurement to detect the positions of the reference mark 34A, 34B, 53A, and 53B. According to the position detection, alignment can be performed at high precision even in the case where no reference marks are formed on the wafer.

In addition, in the above-described present embodiment, the photoresist is removed from the entirety of the ring-like reference mark 52 on the wafer 50. However, only part of the reference area 52 may be removed as in an example case where either only the photoresist on the reference marks is removed, or only the photoresist is removed from local areas including the reference marks. Furthermore, the positions for forming the reference marks are not restricted to the outer peripheral portions (portions on the ring-like reference area 52 in the present embodiment). The positions may be any other portions excluding areas for forming circuit patterns (shot area). For example, the reference marks may be formed on street lines. Still furthermore, at least one of the plurality of alignment marks formed on the wafer may be used as a reference mark.

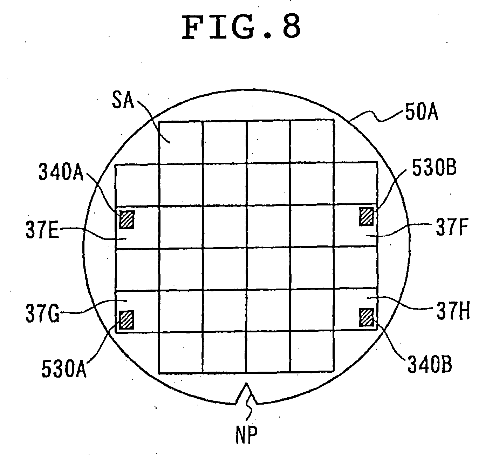

FIG.8 shows a wafer 50A on which predetermined alignment marks are used as reference marks, as described above. In this figure, among a plurality of shot areas SA on the wafer 50A having a notch portion NP, at least one alignment mark 340A, 530B, 530A, or 340B is used as a reference mark in corresponding one of four shot areas 37E, 37F, 37G, and 37H. Photoresist on the alignment marks 340A, 530B, 530A, and 340B is removed by a separately provided resist-removing apparatus (not shown).

In the above-described first and second embodiments, the reference marks (such as the reference mark 34A) are formed on the wafer holders 24A and 24B. However, the reticle marks may be formed in areas different areas on the wafer stages 23A and 23B. In addition, in each of the above-described first to third embodiments, after the reference marks are formed on a plate different from the wafer holder, the plate may be immobilized on the wafer holder. This provides advantages in that the wafer holder and the reference marks can be processed independently of each other, and the manufacture is thereby facilitated. In addition, either without changes being made or with partial changes being made for improvement, the modified examples described in the first embodiment may be applied to other embodiments. Moreover, the number of sets of the wafer stages used in the projection exposure apparatus of each of the individual embodiments is not limited to two, and it may be three or more. For example, the configuration may be modified such that the position of detection by the alignment sensor 12 of the off-the-axis type for the alignment marks and the like is set away from the exchange position where wafers are passed therefrom to the wafer loader system to thereby allow detection by the alignment sensor 12 for the marks, exposure of wafers, and replacement of wafers (wafer holders) to be performed at the same time.

Furthermore, in each of the above-described embodiments, the alignment marks are formed in the individual shot areas on the wafer, and the alignment marks provided in at least three shot areas are detected by the EGA method. However, the arrangement may be modified such that the alignment mark is not provided in the units of the shot area, but, for example, a plurality of alignment marks are instead formed on a peripheral portion of the wafer, and the plurality of alignment marks are detected by the EGA method. In this case, the plurality of alignment marks may either be formed together with circuit patterns in units of the individual layer or be preformed on either the wafer or layers on the surface thereof.

Still furthermore, the EGA method is not limited to the type (disclosed in Japanese Examined Patent Application Publication No.4-47968 and United States Patent No.4,780,617, the disclosures of which are herein incorporated by reference) described in the individual embodiments. The method may be, for example, as disclosed in Japanese Unexamined Patent Application Publication No.5-304077 and corresponding United States Patent No.5,525,808, the disclosures of which are herein incorporated by reference, of a type wherein weight coefficients set corresponding to the alignment marks in the shot areas which are subjected to coordinate detection are used to thereby obtain the above-described error parameters.

Still furthermore, according to the above-described EGA method, the statistical method is used to perform calculation for the array coordinates of the individual shot areas.- However, the calculation method is not limited thereto. For example, positioning is performed for each of at least three shot areas according to a design value (such as the coordinate value used in exposure of the front layer), and concurrently, the alignment sensor 12 of the off-the-axis type is used to obtain the amounts of positional deviations of the alignment marks with respect to the individual index marks. In addition, calculation is performed for the amounts of positional deviations of the individual shot areas according to a statistical method (for example, a least duplicating method), the design value is corrected according to the calculated amount of the positional deviation in units of the shot area, and the wafer movement is controlled according to the corrected value. That is, in the EGA method, the position information, the model expressions, and the like may be arbitrarily determined.

In each of the above-described embodiments, the reticle patterns on the second and upper layers are overlapped with the pattern of each of the shot areas on the wafer and are thereby transferred thereon. However, when the reticle pattern on the first layer is transferred on the wafer, the arrangement of the shot areas on the wafer may be defined using position information obtained through detection by the alignment sensor 12 for at least one of the reference marks (34A to 34D). In addition, in a case where a plurality of alignment marks are preformed on a peripheral portion of the wafer, the transfer procedure may be arranged such that the alignment sensor 12 is used to preliminarily detect the above-described reference marks and the aforementioned plurality of alignment marks, and the first-layer pattern is transferred on the wafer with reference to the plurality of alignment marks according to results of the detection by the alignment sensor 12 and results of the detection by a TTR-type or the TTL-type alignment sensor for the reference marks.

Moreover, the projection exposure apparatus of the above embodiment can be manufactured in the following manner. More specifically, an illumination optical system and a projection optical system each comprising a plurality of lenses are incorporated into the exposure apparatus main body, and then, an optical adjustment is made. Further, the reticle stage and the wafer stage each comprising a large number of mechanical parts are attached to the exposure apparatus main body, and then, wiring and piping connection are made. Furthermore, total adjustments (electric adjustment, operation confirmation, etc.) are made. In this case, it is preferable that the manufacture of the exposure apparatus is carried out in a clean room in which a temperature, cleanliness and the like are suitably controlled.

In the case of manufacturing a semiconductor device on a wafer using the projection exposure apparatus of the above embodiment, the semiconductor device is manufactured by way of the following steps. The steps include a step of making a design of the device function and performance, a step of manufacturing a reticule based on the above step, a step of forming a wafer out of silicon material, a step of carrying out alignment by the projection exposure apparatus of the above embodiment and exposing the reticule pattern on the wafer, a device assembly step (including dicing process, bonding process, packaging process), an inspection step, etc.

In each of the above-described embodiments, although the present invention is applied to the scanning-exposure type projection exposure apparatus, the application field thereof is not limited thereto. The present invention may be applied to various other types of apparatus to obtain the same effects. They include a scanning exposure type or full field exposure type apparatus of a step-and-switch type; a full field exposure type (static exposure type) exposure apparatus of a step-and-repeat exposure type or the like; an exposure apparatus using EUV light, such as X rays, as exposure beams; and a charge-corpuscular-ray exposure apparatus that uses electron rays, ion beams (energy beams), or the like as a light source (energy source).

The exposure apparatus may be used not only as an exposure apparatus for the manufacture of semiconductors, but also as an exposure apparatus for the manufacture of various other devices. They include display devices such as liquid crystal display (LCD) devices to be formed on squarish glass plates, and plasma displays, charge-coupled devices (CCDs); micromachines; and thin-film magnetic heads. In addition, the present invention may be applied to an exposure step (exposure apparatus) using a photolithography step for the manufacture of masks (photomasks, reticles, and the like) on which mask patterns of various devices are formed.

In addition, in the configuration wherein a linear motor is used in a reticle stage system, a movable stage may be held by any method, such as an air-flotation method using air-bearings or magnetic-flotation method. In addition, in a stage system, to reduce the influence of vibrations in step-movement and scanning exposure, the configuration may be built such that a reaction force caused when a movable stage is driven is transferred to a floor.

According to the present invention, at the time of exposure, measurement operations for, for example, marks not covered a photosensitive material are performed, but no other measurement operations are performed. Thereby, high-precision alignment can be performed for an exposure-target substrate on which a photosensitive material is coated.

Furthermore, according to the present invention, a mark not covered by a photosensitive material can be used as a mark that can be detected using, for example, detection beams having the same wavelengths as those of exposure beams, through a projection system (projection optical system). Therefore, the present invention is advantageous in that, when exposure is performed through the projection system, high-precision alignment can be performed for an exposure-target substrate.

The entire disclosure of Japanese Patent Application No.2000-071356 filed on March 14, 2000 including specification, claims, drawings and abstract and the entire disclosure of Japanese Patent Application No. 2001-065078 filed on March 8, 2001 including specification, claims, drawings and abstract, are incorporated herein by reference in their entirety.

Although various exemplary embodiments have been shown and described, the invention is not limited to the embodiments shown. Therefore, the scope of the invention is intended to be limited solely by the scope of the claims that follow.

**Claims**

1. An alignment method which performs alignment of a substrate on which a first mark is formed with respect to an exposure position, comprising:

   measuring and storing a positional relationship between the first mark and a second mark formed in an area different from the first mark, and

   measuring a position of the second mark after the substrate is moved to a vicinity of the exposure position in a state in which relative positions of the first mark and the second mark are maintained to be substantially constant, wherein

   the alignment of the substrate is performed based on the measurement result and the stored positional relationship.

2. An alignment method as recited in claim 1, wherein

   the second mark is formed on a holding member which holds the substrate, and

   the substrate is transferred in a state where the substrate is held by the holding member between the measuring and storing of the positional relationship and the measuring of the position of the second mark.

3. An alignment method as recited in claim 1, wherein

   the first mark is formed on the substrate in an area on which a photosensitive material is coated, and

   the second mark is formed on an area of the substrate from which the photosensitive material is removed.

4. An exposure method which performs exposure of a substrate with an exposure beams through a mask, comprising:

   exposing the substrate after the substrate is aligned with the mask by using the alignment method as recited in claim 1.

5. An exposure method which performs exposure of a second substance through a first substance with an exposure beam, comprising:

   moving a movable body on which the second substance is mounted on a first coordinate system, and detecting a mark on the first substance and reference marks different from the mark with a first mark-detecting system, thereby obtaining first position information;

   moving at least a part of the movable body including the second substance and the reference marks onto a second coordinate system, and detecting the reference marks with a second mask-detecting system, thereby obtaining second position information, the reference marks being respectively provided at a plurality of positions, and at least two of the reference marks being detected by at least one of the first mark-detecting system and the second mask-detecting system; and

   controlling a movement of the second substance on the second coordinate system according to the first position information and the second position information, and exposing the second substance through the first substance with the exposure beams.

6. An exposure method as recited in claim 5, wherein

   the first position information includes transfer position information of a pattern of the first substance on the second substance, the transfer position information being obtained from a result of the detection of the mark on the substrate; and

   the second position information includes a result of the detection of the at least two reference marks, the transfer position information is corrected according to the result of the detection of the reference marks of the first position information, and the second position information, and movement of the second substance is controlled according to information of the correction.

7. An exposure method as recited in claim 6, wherein another movable body different from the movable body is disposed on the second coordinate system, and the detection of the mark on the second substance and the reference marks by the first mark-detecting system and the exposure of the second substance mounted on the another movable body are performed substantially at the same time.

8. An exposure apparatus which performs exposure of a substrate with an exposure beam through a mask, comprising:

a substrate stage which performs positioning of the substrate;
a first mark-detecting system which detects positions of a first mark on the substrate and a second mark formed in an area different from the first mark; and
a second mask-detecting system which detects the position of the second mark with a transfer position of a pattern of the mask being used as a reference.

9. An exposure apparatus as recited in claim 8, wherein

the first mark is formed on the substrate in an area on which a photosensitive material is coated, the second mark is formed on the substrate, or on a holding member which is to hold the substrate and in an area on which the photosensitive material is not coated, and
the first mark-detecting system detects a detection-target mark by using a detecting beam having a wavelength band that is different from that of the exposure beam and having a wavelength width that is wider than that of the exposure beam.

10. An exposure apparatus as recited in claim 8, wherein the second mark is formed on a holding member which is to hold the substrate on the substrate stage.

11. An exposure apparatus as recited in claim 8, wherein the pattern of the mask is transferred onto the substrate through a projection system, and the second mask-detecting system detects the position of the second mark through at least a part of the projection system.

12. An exposure apparatus as recited in claim 8, wherein

the substrate stage comprises a first stage and a second stage which positions a first substrate and a second substrate as the substrate, respectively, and
two units of the first mark-detecting systems are provided corresponding to the first stage and the second stage.

13. An exposure apparatus as recited in claim 8, wherein

the substrate stage comprises a first stage and a second stage which positions a first substrate and a second substrate as the substrate, respectively, and
an exchange mechanism is provided which exchanges at least a portion of the first stage which holds the first substrate with at lease a portion of the second stage which holds the second substrate.

14. An exposure apparatus as recited in claim 8, wherein
a carrying system is provided to carry the substrate from a detection area of the second mask-detecting system onto the substrate stage.

15. A device manufacturing method, comprising:
transferring a mask pattern onto a workpiece by using the exposure apparatus as recited in claim 8.

16. An exposure apparatus which performs exposure of a second substrate through a first substance with an exposure beam, comprising:

a movable body on which the second substance is mounted, and on which a plurality of reference marks which are different from a mark on the second substance are provided;
a first measurement system which includes a first mark-detecting system which detects the mark on the second substance and the reference marks, which defines a first coordinate system on which the movable body is disposed and on which a detection center of the first mark-detecting system is set, and which measures first position information regarding the mark on the second substance and the reference marks;
a second measurement system which includes a second mark-detecting system which detects the reference marks, which defines a second coordinate system on which at least a part of the movable body is disposed and on which a detection center of the second mark-detecting system is set, and which measures second position information regarding the reference marks, at least two of the plurality of reference marks being detected by at least one of the first measurement system and the second measurement system, and
a controller which controls movement of the second substance on the second coordinate system according to the first position information and the second position information when the second substance is exposed.

17. An exposure apparatus as recited in claim 16, wherein

the second position information includes a result of the detection of the at least two reference marks, and said controller performs calculation according to a result of the detection of the mark on the substrate of the first position information to obtain transfer position information of a pattern of the first substance on the second substance, and said controller corrects the transfer position information according to the result of the detection of the reference marks of the first position information and to the second position information.

18. An exposure apparatus as recited in claim 17, wherein

the movable body includes a holder which holds the second substance and on which the plurality of reference marks are integrally provided.

19. An exposure apparatus as recited in claim 18, further comprising:

another movable body different from the movable body disposed on the second coordinate system, and
an exchange mechanism which transfers at least the holder holding the substrate which is separated from the movable body disposed on the first coordinate system onto the another movable body.

20. An exposure apparatus as recited in claim 19, further comprising:

a first housing in which at least a part of the movable body and the first measurement system is disposed, and
a second housing in which at least a part of the another movable body and the second measurement system is disposed, wherein
the exchange mechanism moves at least the holder between the first housing and the second housing.

21. An exposure apparatus as recited in claim 18, further comprising:

another movable body different from the movable body disposed on the second coordinate system, wherein
the movable body is moved onto the second coordinate system after the another movable body is moved out of the second coordinate system.

22. An exposure apparatus as recited in claim 21, wherein

the movable body is exchanged with the another movable body and is thereby moved onto the second coordinate system.

23. An exposure apparatus as recited in claim 21, further comprising:

a third measurement system which includes a third mark-detecting system which detects the mark on the second substance disposed on the another movable body and reference marks different from the mark on the second substance and which defines a third coordinate system on which at least a part of the another movable body is disposed and on which a detection center of the third mark-detecting system is set, wherein
at least a part of the movable body is moved between the first coordinate system and the second coordinate system, and at least a part of the another movable body is moved between the second coordinate system and the third coordinate system.

24. An exposure apparatus as recited in claim 17, further comprising:

another movable body different from the movable body disposed on the second coordinate system, wherein
said controller performs the detection of the mark on the second substance and the reference marks by the first mark-detecting system and the exposure of the second substance mounted on the another movable body substantially at the same time.

# FIG.1

EP 1 134 618 A2

# FIG.2

EP 1 134 618 A2

# FIG.3A

# FIG.3B

# FIG.4

# FIG.5

# FIG.6

# FIG.7A

# FIG.7B

# FIG.8